# EUROPEAN PATENT APPLICATION

(11) **EP 1 168 054 A1**
(43) Date of publication of application: **02.01.2002**
(21) Application number: 00987701.0
(22) Date of filing: 21.12.2000
(51) Int. Cl.: G02F 1/1368, G02F 1/1335, G09F 9/30, H01L 29/786, H01L 21/336

(54) **TFT ARRAY SUBSTRATE, METHOD OF MANUFACTURE THEREOF, AND LCD WITH TFT ARRAY SUBSTRATE**

(30) Priority: 28.12.1999 JP 37271399
(71) Applicant: MATSUSHITA ELECTRIC INDUSTRIAL CO., LTD., Kadoma-shi, Osaka 571-8501 (JP)
(72) Inventor: OGAWA, Kazufumi, Nara-shi, Nara 630-8101 (JP)
(74) Representative: Dempster, Benjamin John Naftel
(86) International application number: JP0009122
(87) International publication number: WO0148547

(57) **Abstract**

A structure for a TFT array substrate is provided, that can be produced using only two or three photomasks. This can be achieved with a TFT array substrate including pixel electrodes (14') and TFTs (16) including a silicon semiconductor film deposited over the insulating substrate (1), a gate insulator film (4') formed over a channel region of the silicon semiconductor film, a gate electrode (5') formed over the gate insulator film (4'), a gate electrode metal-oxide film (7) covering a surface of the gate electrode (5'), a source electrode (12) covering at least a lateral surface of the gate electrode metal-oxide film (7) on the source region side and a source region, and a drain electrode (13) formed covering at least a lateral surface on the drain region side of the gate electrode metal-oxide film (7) and a drain region, the source electrode (12) and the drain electrode (13) being separated from one another at an upper surface of the gate electrode metal-oxide film (7).

## Description

### TECHNICAL FIELD

The present invention relates to a new structure for a TFT array substrate used in a liquid crystal display device, a method for manufacturing the same, and a liquid crystal display device using the same.

### BACKGROUND ART

Conventionally, five to nine photomasks are used in manufacturing a TFT (thin film transistor) array substrate for a color liquid crystal display device. Therefore, when a large number of photomasks are used, the manufacturing process is complicated accordingly, making it difficult to reduce manufacturing costs.

On the other hand, with regard to the manufacturing process for diode array substrates, a technology has been proposed (JP S62-502361A) in which the number of photomasks used is reduced to as low as two masks. This technology, however, is not only inapplicable to TFT array substrates, but there is a problem that diode array substrates are not suited for color television, because the performance of diode array substrates is inferior to that of TFT array substrates.

### DISCLOSURE OF THE INVENTION

An object of the present invention is to provide a structure of a TFT array substrate, in which the number of photomasks used can be reduced and in which a simplification of the manufacturing steps and a reduction in manufacturing costs is achieved, and a method for manufacturing the same, with which such a substrate can be productively manufactured. Furthermore, it is an object of the present invention to provide an inexpensive high-performance liquid crystal display device using such a substrate.

A group of inventions for achieving the aforementioned objects is configured as follows:
[1] Invention relating to a top gate TFT array substrate A top gate TFT array substrate, in which pixel electrodes (14') and TFTs (16) driving the pixel electrodes are formed in a matrix on an insulating substrate (1); is characterized in that the TFTs include:
   a silicon semiconductor film deposited over the insulating substrate (1);
   a gate insulator film (4') formed over a channel region of the silicon semiconductor film;
   a gate electrode (5') formed over the gate insulator film (4');
   a gate electrode metal-oxide film (7) covering a surface of the gate electrode (5');
   a source electrode (12) covering at least a lateral surface of the gate electrode metal-oxide film (7) on the source region side and a source region; and
   a drain electrode (13) formed covering at least a lateral surface on the drain region side of the gate electrode metal-oxide film (7) and a drain region, the source electrode (12) and the drain electrode (13) being separated from one another at an upper surface of the gate electrode metal-oxide film (7);
   wherein the pixel electrodes (14') are formed at parts of the substrate where the TFTs (16) are not formed, and the pixel electrodes (14') are electrically connected to the drain region of the silicon semiconductor film via the drain electrode (13).

With the top gate TFT array substrate of this configuration, a TFT array substrate with a performance that is equal to or better than that of a conventional substrate can be manufactured using 3 photomasks. More specifically, it can be manufactured with a manufacturing method of the following configuration.

A method for manufacturing a top gate TFT array substrate provided with
a group of TFTs including at least:
   a silicon semiconductor film deposited over an insulating substrate (1);
   a gate insulator film (4') formed over a channel region of the silicon semiconductor film;
   a gate electrode (5') formed over the gate insulator film (4');
   a gate electrode metal-oxide film (7) covering a surface of the gate electrode (5');
   a source electrode (12) covering at least a lateral surface of the gate electrode metal-oxide film (7) on the source region side and a source region; and
   a drain electrode (13) formed covering at least a lateral surface on the drain region side of the gate electrode metal-oxide film (7) and a drain region, the source electrode (12) and the drain electrode (13) being separated from one another at an upper surface of the gate electrode metal-oxide film (7); and
a group of pixel electrodes formed on parts of the substrate where the TFTs (16) are not formed, and that are electrically connected to the drain region of the silicon semiconductor film via the drain electrode (13);
   is characterized by:
   a first layering step, in which an intrinsic silicon semiconductor film layer (3) not doped with impurities, a gate insulator film layer (4), and a gate metal film layer (5) are sequentially layered over the insulating substrate (1);
   a first photolithography step, in which the gate metal film layer (5) is etched with photolithography using a first resist pattern (6), forming the gate electrode (5') and a gate metal wiring pattern electrically connected thereto;
   a metal-oxide film formation step, in which a surface of the gate electrode (5') and the gate metal wiring pattern are oxidized, forming the gate electrode metal-oxide film (7) that covers an upper and a lateral surface of the gate electrode (5'), and a gate metal wiring oxide film that covers an upper and a lateral surface of the gate metal wiring pattern;
   a gate insulator film formation step, in which the gate insulator film layer (4) is etched with the oxide film as a mask, forming the gate insulator film (4');
   a second layering step, in which a doped silicon semiconductor film layer (8) doped with impurities, a contact metal film layer (9), and a source/drain metal film layer (10) are sequentially layered after the gate insulator film formation step;
   a second photolithography step, in which the source/drain metal film layer (10), the contact metal film layer (9), and the doped silicon semiconductor film layer (8) doped with impurities, which were layered in the second layering step, and the intrinsic silicon semiconductor film layer (3) not doped with impurities are sequentially etched with photolithography using a second resist pattern (11), forming TFTs (16) on the substrate; and
   a pixel electrode forming third photolithography step, in which a pixel electrode film layer (14) is deposited over the TFTs (16), after which the pixel electrode film layer (14) is etched with photolithography using a third resist pattern (15), forming a group of pixel electrodes (14') connected to the drain electrode (13).

In the above manufacturing method, an anodization process can be used as the oxidation method in the metal-oxide film formation step. Here, "anodization" means letting a current flow through the electrode metal while it is immersed in an electrolyte, and oxidizing the electrode metal surface. With this method, it is possible to form an insulating film made of a metal-oxide film that is self-aligning on the surface of gate electrodes and the gate metal wiring that is electrically connected to the gate electrodes. Furthermore, with this method, the metal-oxide film can be formed at low temperatures with high efficiency.

In the above manufacturing method, the intrinsic silicon semiconductor film layer (3) can be an intrinsic amorphous silicon film layer not doped with impurities (or an undoped low-temperature polysilicon film), and the doped silicon semiconductor film layer (8) can be a doped amorphous silicon film layer doped with impurities. With amorphous silicon, the semiconductor film layer can be formed with high efficiency by CVD (chemical vapor deposition), for example. Furthermore, with the above manufacturing method using amorphous silicon, it is easy to form a channel region made of an intrinsic amorphous silicon film, and a source region and a drain region made of two layers (mixed layers) of an intrinsic amorphous silicon film and a doped amorphous silicon film. Also, the step of implanting impurities to form the source region and the drain region becomes unnecessary. Consequently, the productivity for the TFTs is increased.

Furthermore, with the manufacturing method of this configuration, TFTs are formed, in which a doped silicon semiconductor film (8') is interposed between the gate electrode metal-oxide film (7) and the source and drain electrodes or the contact electrodes (9'). With this structure, the gate electrode (5') and the source and drain electrodes, as well as the gate electrode (5') and the contact electrodes (9'), are insulated by two layers: the gate electrode metal-oxide film (7) and the doped silicon semiconductor film (8'). Consequently, gate leaks are reduced.

In the second photolithography step of the above manufacturing method, it is preferable that the layers that have been layered over the gate electrode metal-oxide film (7) are sequentially etched until the upper surface of the gate electrode metal-oxide film (7) is reached, forming the source electrode (12) and the drain electrode (13). With this method, it is easy to manufacture TFTs having a source electrode and a drain electrode that are separated from another at an upper surface of the gate electrode metal-oxide film (7).

It is preferable that at least the intrinsic silicon semiconductor film layer (3), the gate insulator film layer (4), and the gate metal film layer (5) are formed consecutively. By forming these layers consecutively, it is possible to reduce interface states between the layers.

The source/drain metal film layer (10) and the contact metal film layer (9) can be formed of the same material and in a single layer. With this configuration, the manufacturing process can be further simplified, and the production efficiency can be improved even more.

It is preferable that, in the first layering step, the intrinsic silicon semiconductor film layer is formed after an undercoat film has been layered on a surface of the insulating substrate (1), because by layering an undercoat film, the impurities included in the substrate can be prevented from diffusing and migrating into the semiconductor film layers.

Furthermore, with the above manufacturing method, it is possible to manufacture a top-gate TFT array substrate, in which the source electrode (12) is connected electrically to the source region of the silicon semiconductor film via the contact electrode (9'), by disposing contact electrodes (9') between the gate electrode metal-oxide film (7) and the source electrode (12), and between the gate electrode metal-oxide film (7) and the drain electrode (13), and by connecting the pixel electrodes (14') electrically with the drain region of the silicon semiconductor film via the drain electrode (13) and the contact electrode (9'). With a TFT array substrate of this structure, the contact electrodes prevent the migration of metal (such as aluminum) in the source electrode or the drain electrode into the semiconductor film layers, so that stable transistor characteristics are attained.

With the above manufacturing method, the surface of the gate metal wiring that is electrically connected to the gate electrode (5') is covered by a gate metal-oxide film of oxidized gate metal. Consequently, it is easy to realize a structure, wherein the gate metal wiring and source metal wiring that is electrically connected to the source electrode (12) intersect via the gate metal-oxide film and the doped silicon semiconductor film deposited thereon. With such a structure, the insulation between the two wirings is good, so that the risk of internal short circuits is small.

It should be noted that the source metal wiring and the gate metal wiring always intersect via the gate metal-oxide film and the doped silicon semiconductor film deposited thereon, because in this intersection portion, the metal-oxide film of the metal wiring that is located above the intersection portion (that is, the metal-oxide film of either the source metal wiring or the gate metal wiring) functions as a mask, so that in the pixel electrode forming third photolithography step, the doped silicon semiconductor film layer on the lower the metal wiring is not etched.

Furthermore, in the above manufacturing method, the source metal wiring electrically connected to the source electrode (12) and the contact electrodes (9') are formed by patterning a metal film layer made of the same material and in a single layer, which is deposited over the insulating substrate (1). With this configuration, the process can be further simplified.

Also, with the above manufacturing method, it is easy to form a source wiring deposition layer with a three-layered structure made by sequentially layering a doped silicon semiconductor film, a contact metal film, and a source metal film. In this source wiring deposition layer, the source metal wiring acting as conductive leads is constituted primarily by the source metal film layer, but because it is a three-layered structure, there is no or only little level difference between the source metal wiring and the source electrode, so that it is convenient for example in the case that a liquid crystal alignment film is formed.

### [2] Invention relating to a liquid crystal display device using this top gate TFT array substrate

A liquid crystal display device includes:
a first substrate, wherein a liquid crystal alignment film is formed on a surface of a top gate TFT array substrate, wherein pixel electrodes and TFTs driving the pixel electrodes are arranged in a matrix on an insulating substrate; and
a second substrate including a color filter and an opposing pixel electrode, the first and the second substrate being arranged in opposition to one another with their electrode surfaces facing inward, and a liquid crystal being injected into a gap between the two substrates;
wherein the top gate TFT array substrate includes:
top gate TFTs including:
   a silicon semiconductor film deposited over an insulating substrate (1);
   a gate insulator film (4') formed over a channel region of the silicon semiconductor film;
   a gate electrode (5') formed over the gate insulator film (4');
   a gate electrode metal-oxide film (7) covering a surface of the gate electrode (5');
   a source electrode (12) covering at least a lateral surface of the gate electrode metal-oxide film (7) on the source region side and a source region; and
   a drain electrode (13) formed covering at least a lateral surface on the drain region side of the gate electrode metal-oxide film (7) and a drain region, the source electrode (12) and the drain electrode (13) being separated from one another at an upper surface of the gate electrode metal-oxide film (7); and
   a pixel electrodes (14') formed on parts of the substrate where the TFTs (16) are not formed, and that are electrically connected to the drain region of the silicon semiconductor film via the drain electrode (13).

In this configuration, the TFTs (16) and the pixel electrodes (14') on the top gate TFT array substrate can be covered with a protective film. Furthermore, the protective film can be made of an inorganic material. If the TFTs and the pixel electrodes are covered by a protective film, damage of the TFTs etc. can be prevented, and in particular a protective film made of an inorganic material (such as silica) has excellent protective properties, so that it improves the durability of the TFT array substrate.

The above liquid crystal display device can be manufactured by a manufacturing method of the following configuration: A method for manufacturing a liquid crystal display device, including:
a TFT array substrate manufacturing process for manufacturing a top gate TFT array substrate including:
   a group of TFTs including:
      a silicon semiconductor film deposited over an insulating substrate (1);
      a gate insulator film (4') formed over a channel region of the silicon semiconductor film;
      a gate electrode (5') formed over the gate insulator film (4');
      a gate electrode metal-oxide film (7) covering a surface of the gate electrode (5');
      a source electrode (12) covering at least a lateral surface of the gate electrode metal-oxide film (7) on the source region side and a source region; and
      a drain electrode (13) formed covering at least a lateral surface on the drain region side of the gate electrode metal-oxide film (7) and a drain region, the source electrode (12) and the drain electrode (13) being separated from one another at an upper surface of the gate electrode metal-oxide film (7); and
   a group of pixel electrodes formed on parts of the substrate where the TFTs (16) are not formed, and that are electrically connected to the drain region of the silicon semiconductor film via the drain electrode (13);
an alignment film formation process, wherein a liquid crystal alignment film is formed on a surface of the TFT array substrate to make a first substrate; and
a device assembly process, wherein a liquid crystal display device is made by superposing the first substrate and a second substrate, which includes a color filter group and an opposing electrode, with their electrode surfaces facing inward, and injecting a liquid crystal into a gap between the two substrates;
   wherein the TFT array substrate manufacturing process includes:
   a first layering step, wherein an intrinsic silicon semiconductor film layer (3) not doped with impurities, a gate insulator film layer (4), and a gate metal film layer (5) are sequentially layered over the insulating substrate (1);
   a first photolithography step, in which the gate metal film layer (5) is etched with photolithography using a first resist pattern (6), forming the gate electrode (5') and gate metal wiring pattern electrically connected thereto;
   a metal-oxide film formation step, in which the surfaces of the gate electrode (5') and the gate metal wiring pattern are oxidized to form the gate electrode metal-oxide film (7) that covers the upper and lateral surface of the gate electrode (5'), and the gate metal wiring oxide film that covers the upper and lateral surface of the gate metal wiring pattern;
   a gate insulator film formation step, in which the gate insulator film layer (4) is etched, with the oxide film as a mask, forming the gate insulator film (4');
   a second layering step, in which a doped silicon semiconductor film layer (8) doped with impurities, a contact metal film layer (9), and a source/drain metal film layer (10) are sequentially layered after the gate insulator film formation step;
   a second photolithography step, in which the layers that have been layered in the second layering step and the intrinsic silicon semiconductor film layer (3) are sequentially etched with photolithography using a second resist pattern (11), forming a TFT (16); and
   a pixel electrode forming third photolithography step of further depositing a pixel electrode film layer (14) on the substrate surface, after which the pixel electrode film layer (14) is etched with photolithography using a third resist pattern (15), forming a group of pixel electrodes (14') that are connected to the drain electrode (13), the pixel electrode forming third photolithography step being performed after the second photolithography step.

   In this manufacturing method, it is possible to add, between the pixel electrode formation step and the alignment film formation step, a protective film deposition step of covering the TFTs formed on the substrate and the pixel electrodes with a protective film. If the TFTs and the pixel electrodes are covered by a protective film, the protective film prevents damage of the TFTs, etc. Consequently, the durability of the TFT array substrate is improved. Furthermore, there is also the effect that the protective film can be used as a mask. More specifically, taking the protective film as a mask, the input/output terminal portions can be formed easily, by etching the oxide film on the gate metal wiring surface at the periphery of the TFT array substrate.
   This liquid crystal display device has the top gate TFT array substrate explained in [1] as a principal component. Consequently, the liquid crystal display device and the method for manufacturing the same can of course also include the features described under [1], but in order to avoid duplicate explanations, these explanations have been omitted.

### [3] Invention relating to a reflective TFT array substrate

A reflective TFT array substrate, wherein TFTs and reflective pixel electrodes driven by the TFTs are arranged in a matrix on an insulating substrate; is characterized in that the TFTs include:
a silicon semiconductor film deposited over an insulating substrate (1);
a gate insulator film (4') formed over the channel region of the silicon semiconductor film;
a gate electrode (5') formed over the gate insulator film (4');
a gate electrode metal-oxide film (7) covering a surface of the gate electrode (5');
a source electrode (42) covering at least a lateral surface of the gate electrode metal-oxide film (7) on the source region side and a source region; and
a drain electrode (43) formed covering at least the lateral surface on the drain region side of the gate electrode metal-oxide film (7) and a drain region, the source electrode (42) and the drain electrode (43) being separated from one another at the upper surface of the gate electrode metal-oxide film (7);
wherein the drain electrode (43) also functions as a reflective pixel electrode.

A reflective TFT array substrate with this configuration can be manufactured using only two photomasks. More specifically, it can be manufactured with a manufacturing method of the following configuration.

A method for manufacturing a reflective TFT array substrate, the TFT array substrate includes:
a silicon semiconductor film deposited over an insulating substrate (1);
a gate insulator film (4') formed over the channel region of the silicon semiconductor film;
a gate electrode (5') formed over the gate insulator film (4');
a gate electrode metal-oxide film (7) covering a surface of the gate electrode (5');
a source electrode (42) covering at least a lateral surface of the gate electrode metal-oxide film (7) on the source region side and a source region; and
a drain electrode (43) formed covering at least a lateral surface on the drain region side of the gate electrode metal-oxide film (7) and a drain region, the source electrode (42) and the drain electrode (43) being separated from one another at an upper surface of the gate electrode metal-oxide film (7);
   wherein the drain electrode (43) also functions as a reflective pixel electrode (47);
the method including:
a first layering step, wherein an intrinsic silicon semiconductor film layer (3) not doped with impurities, a gate insulator film layer (4), and a gate metal film layer (5) are sequentially layered over the insulating substrate (1);
a first photolithography step, in which the gate metal film layer (5) is etched with photolithography using a first resist pattern (6), forming the gate electrode (5') and a gate metal wiring pattern electrically connected thereto;
a metal-oxide film formation step, in which the surfaces of the gate electrode (5') and the gate metal wiring pattern are oxidized to form the gate electrode metal-oxide film (7) that covers the upper and lateral surface of the gate electrode (5'), and the gate metal wiring oxide film that covers the upper and lateral surface of the gate metal wiring pattern;
a gate insulator film formation step, in which the gate insulator film layer (4) is etched, with the oxide film as a mask, forming the gate insulator film (4');
a second layering step, in which a doped silicon semiconductor film layer (8) doped with impurities, a contact metal film layer (9), and an optically reflective source/drain metal film layer (10) are sequentially deposited after the gate insulator film formation step;
a second photolithography step, in which the source/drain metal film layer (10), the contact metal film layer (9), the doped silicon semiconductor film layer (8) doped with impurities that were layered with the second layering step, and the intrinsic silicon semiconductor film layer (3) not doped with impurities, are sequentially etched with photolithography using a second resist pattern (41) to form TFTs and reflective pixel electrodes (47) formed in one piece with the drain electrode.

Here, the manufacturing method can also be configured as follows.

In the metal-oxide film formation step, the surface of the gate electrode and the gate metal wiring pattern can be oxidized by anodization. If anodization is used, then an insulating film made of a metal-oxide film can be formed by self-alignment and at low temperatures on the surface of the gate electrode and the gate metal wiring pattern, so that the manufacturing efficiency is good.

Furthermore, the intrinsic silicon semiconductor film layer (3) can be made of an intrinsic amorphous silicon film layer not doped with impurities, and the doped silicon semiconductor film layer (8) can be made of an n-type doped amorphous silicon film layer doped with n-type impurities. With an amorphous silicon film layer, semiconductor film layers can be formed with high productivity by using CVD (chemical vapor deposition), for example. Moreover, in accordance with the above-described manufacturing method, it is easy to form a channel region made of an intrinsic amorphous silicon film, and a source and a drain region made two layers (mixed layers): an intrinsic amorphous silicon film and a doped amorphous silicon film. Consequently, to form source and drain regions, the step of implanting impurities into the semiconductor film layer becomes unnecessary. Furthermore, with this manufacturing method, it is possible to form a TFT, in which a doped silicon semiconductor film (8') is placed between the gate electrode metal-oxide film (7) and the source and drain electrodes, or the contact electrodes (9').

Also, in the second photolithography step, the layers that have been layered on the gate electrode metal-oxide film (7) can be sequentially etched until an upper surface of the gate electrode metal-oxide film (7) is reached, forming at least the source electrode (42) and the drain electrode (43), which also functions as a reflective pixel electrode. With this method, it is possible to manufacture, with high productivity, a TFT having a source electrode and a drain electrode that are separated from one another at the upper surface of the gate electrode metal-oxide film (7). Furthermore, a simplified structure is adopted, in that the drain electrode also functions as the reflective pixel electrode, so that it is possible to manufacture a reflective TFT array by using altogether only two photomasks.

Furthermore, it is possible to make the source/drain metal film layer (10) of aluminum or an aluminum alloy. Aluminum and aluminum alloys have excellent conductivity and optical reflectivity, so that with this configuration, it is easy to manufacture, with high productivity, a reflective TFT array substrate with excellent reflectivity

It is also possible to make the source/drain metal film layer (10) and the contact metal film layer (9) are made of the same material and in a single layer. With this configuration, the layering process is further simplified, and the etching becomes simple, so that the productivity can be increased even further.

Furthermore, in the first layering step, it is also possible to form an undercoat film between the surface of the insulating substrate and the silicon semiconductor film. If an undercoat film is disposed between the substrate and the semiconductor film layer, impurities included in the substrate can be prevented from diffusing and migrating into the semiconductor film layers, so that the semiconductor characteristics are stabilized.

With the above-described method for manufacturing a reflective TFT array substrate, it is possible to manufacture, for example, reflective TFT array substrates with the following structure.
i) a reflective TFT array substrate, wherein contact electrodes (44) are disposed between the gate electrode metal-oxide film (7) and the source electrode (42), and between the gate electrode metal-oxide film (7) and the drain electrode (43), which also serves as the pixel electrode;
ii) a reflective TFT array substrate, wherein a doped silicon semiconductor film (45) doped with impurities is disposed between the gate electrode metal-oxide film (7) and the contact electrodes (44);
iii) a reflective TFT array substrate, wherein the surface of the gate metal wiring electrically connected to the gate electrode (5') is covered with a gate metal-oxide film of oxidized gate metal, and wherein the source metal wiring electrically connected to the source electrode (42) and the gate metal wiring intersect via this film;
iv) a reflective TFT array substrate, wherein the source electrode (42), the source metal wiring electrically connected thereto, the drain electrode (43) also functioning as a reflective pixel electrode, the drain metal wiring electrically connected thereto, and the contact electrodes (44) are formed by patterning a metal film layer made of the same material and in a single layer, which is deposited over the insulating substrate (1);
v) a reflective TFT array substrate, wherein the metal film layer made of the same material and in a single layer is made of aluminum or an aluminum alloy;
vi) a reflective TFT array substrate, wherein the intrinsic silicon semiconductor film is an intrinsic amorphous silicon film not doped with impurities, and the doped silicon semiconductor film is an n-type amorphous silicon film doped with n-type impurities;
vii) a reflective TFT array substrate, wherein a source wiring deposition layer including the source metal wiring is a three-layered structure made by sequentially depositing the doped silicon semiconductor film, a contact metal film, and a source metal film;
viii) a reflective TFT array substrate, wherein an undercoat film (2) is deposited between the insulating substrate (1) and the intrinsic silicon semiconductor film not doped with impurities.

### [4] Invention relating to a reflective liquid crystal display device using the above reflective TFT array substrate

A reflective liquid crystal display device includes:
a first substrate, wherein a liquid crystal alignment film is formed on a surface of a reflective TFT array substrate, wherein reflective pixel electrodes and TFTs driving the reflective pixel electrodes are arranged in a matrix on an insulating substrate; and
a second substrate including a color filter and an opposing pixel electrode arranged on the color filter, the first and the second substrate being arranged in opposition to one another with their electrode surfaces facing inward, and a liquid crystal being injected into a gap between the two substrates;
wherein the reflective TFT array substrate includes:
a silicon semiconductor film deposited over an insulating substrate (1);
a gate insulator film (4') formed over a channel region of the silicon semiconductor film;
a gate electrode (5') formed over the gate insulator film (4');
a gate electrode metal-oxide film (7) covering the surface of the gate electrode (5');
a source electrode (42) covering at least the lateral surface of the gate electrode metal-oxide film (7) on the source region side and a source region; and
a drain electrode (43) formed covering at least the lateral surface on the drain region side of the gate electrode metal-oxide film (7) and a drain region, the source electrode (42) and the drain electrode (43) being separated from one another at the upper surface of the gate electrode metal-oxide film (7);
   wherein the drain electrode (43) also functions as a reflective pixel electrode.

This device can be manufactured with a manufacturing method of the following configuration.

A method for manufacturing such a liquid crystal display device, includes:
a reflective TFT array substrate manufacturing process for manufacturing a reflective TFT array substrate including:
   a silicon semiconductor film deposited over an insulating substrate (1);
   a gate insulator film (4') formed over a channel region of the silicon semiconductor film;
   a gate electrode (5') formed over the gate insulator film (4');
   a gate electrode metal-oxide film (7) covering a surface of the gate electrode (5');
   a source electrode (42) covering at least a lateral surface of the gate electrode metal-oxide film (7) on the source region side and a source region; and
   a drain electrode (43) formed covering at least a lateral surface on the drain region side of the gate electrode metal-oxide film (7) and a drain region, the source electrode (42) and the drain electrode (43) being separated from one another at an upper surface of the gate electrode metal-oxide film (7), wherein the drain electrode (43) also functions as a reflective pixel electrode;
a first substrate production process of forming a liquid crystal alignment film on a surface of the reflective TFT array substrate; and
a liquid crystal cell assembly process, in which the first substrate, and a second substrate, which is provided with a color filter group and an opposing electrode, are superposed with their electrode surfaces facing inward and a liquid crystal is injected into a gap between both substrates to form a liquid crystal cell;
   wherein the reflective TFT array substrate manufacturing process includes:
   a first layering step, in which at least an intrinsic silicon semiconductor film layer (3) not doped with impurities, a gate insulator film layer (4), and a gate metal film layer (5) are sequentially layered over the insulating substrate (1);
   a first photolithography step, in which the gate metal film layer (5) is etched with photolithography using a first resist pattern (6), forming the gate electrode (5') and gate metal wiring pattern electrically connected thereto;
   a metal-oxide film formation step, in which the surfaces of the gate electrode (5') and the gate metal wiring pattern are oxidized to form the gate electrode metal-oxide film (7) that covers the upper and lateral surface of the gate electrode (5'), and the gate metal wiring oxide film that covers the upper and lateral surface of the gate metal wiring pattern;
   a gate insulator film formation step, in which the gate insulator film layer (4) is etched, with the oxide film as a mask, forming the gate insulator film (4');
   a second layering step, in which a doped silicon semiconductor film layer (8) doped with impurities, a contact metal film layer (9), and an optically reflective source/drain metal film layer (10) are sequentially layered after the gate insulator film formation step;
   a second photolithography step, in which the layers that have been layered in the second layering step and the intrinsic silicon semiconductor film layer (3) are sequentially etched with photolithography using a second resist pattern (41), forming a source electrode and a drain electrode also functioning as a reflective pixel electrode.

   In this manufacturing method, it is possible to add, between the reflective TFT array substrate manufacturing process and the alignment film formation process, a protective film deposition step of covering the surface of the reflective TFT array substrate with a protective film. An inorganic material, such as silica, can be used for the protective film.
   The principal element of the reflective liquid crystal display device with the above configuration is the reflective TFT array substrate, which has been explained already. Therefore, further explanations have been omitted.

### [5] Invention relating to an in-plane switching TFT array substrate (A)

An in-plane switching TFT array substrate includes first comb-shaped pixel electrode portions (79), second comb-shaped pixel electrode portions (80) serving as opposing electrodes, and TFTs (78) driving the first comb-shaped pixel electrode portions (79), arranged in a matrix on an insulating substrate (1);
the TFTs (78) including:
   a silicon semiconductor film deposited over an insulating substrate (1);
   a gate insulator film (73) formed over a channel region of the silicon semiconductor film;
   a gate electrode (71) formed over the gate insulator film (73);
   a gate electrode metal-oxide film (72) covering the surface of the gate electrode (71);
   a source electrode (76') covering at least a lateral surface of the gate electrode metal-oxide film (72) on the source region side and a source region; and
   a drain electrode (76") covering at least a lateral surface on the drain region side of the gate electrode metal-oxide film (72) and a drain region, the source electrode (76') and the drain electrode (76") being separated from one another at an upper surface of the gate electrode metal-oxide film (72);
   wherein the first comb-shaped pixel electrode portions (79) are formed at a part of the substrate where the TFTs (78) are not formed, and include:
   a first pixel silicon semiconductor film (3") deposited over the insulating substrate (1);
   a first pixel insulator film (73') formed over the first pixel silicon semiconductor film (3");
   a first pixel electrode (71') formed over the first pixel insulator film (73'); and
a first pixel electrode oxide film (72') covering an upper surface and a lateral surface of the first pixel electrode (71').

This in-plane switching TFT array substrate can be manufactured by a manufacturing method of the following configuration, which uses only two photomasks. Such a method for manufacturing an in-plane switching TFT array substrate, wherein formed on the same substrate are:
TFTs (78) including:
   a silicon semiconductor film deposited over an insulating substrate (1);
   a gate insulator film (73) formed over a channel region of the silicon semiconductor film;
   a gate electrode (71) formed over the gate insulator film (73);
   a gate electrode metal-oxide film (72) covering a surface of the gate electrode (71);
   a source electrode (76') covering at least a lateral surface of the gate electrode metal-oxide film (72) on the source region side and a source region;
   a drain electrode (76") covering at least a lateral surface on the drain region side of the gate electrode metal-oxide film (72) and a drain region, the source electrode (76') and the drain. electrode (76") being separated from one another at an upper surface of the gate electrode metal-oxide film (72);
first comb-shaped pixel electrode portions (79), that are formed at a part of the substrate where the TFTs (78) are not formed, and include:
   a first pixel silicon semiconductor film (3") deposited over the insulating substrate (1);
   a first pixel insulator film (73') formed over the first pixel silicon semiconductor film (3");
   a first pixel electrode (71') formed over the first pixel insulator film (73'); and
   a first pixel electrode oxide film (72') covering an upper surface and a lateral surface of the first pixel electrode (71'); and
second comb-shaped pixel electrode portions (80) serving as opposing electrode portions; includes:
   a first layering step, in which an intrinsic silicon semiconductor film layer (3) not doped with impurities, a gate insulator film layer (4), and a gate metal film layer (5) are sequentially layered over the insulating substrate (1);
   a first photolithography step, in which the gate metal film layer (5) is etched with photolithography using a first resist pattern (70), forming the gate electrode (71), a gate metal wiring pattern electrically connected thereto, and the first pixel electrode (71');
   a metal-oxide film formation step, in which the surfaces of the gate electrode (71), the gate metal wiring pattern, and the first pixel electrode (71') and the gate metal wiring pattern are oxidized to form the gate electrode metal-oxide film (72) that covers the upper and lateral surface of the gate electrode (71), the gate metal wiring oxide film that covers the upper and lateral surface of the gate metal wiring pattern, and the first pixel electrode oxide film (72') that covers the upper and lateral surface of the first pixel electrode (71');
   an insulator film formation step, in which the gate insulator film layer (4) is etched, with the oxide film as a mask, forming the gate insulator film (73) and the first pixel insulator film (73');
   a second layering step, in which a doped silicon semiconductor film layer (74) doped with impurities, a contact metal film layer (75), and a source/drain metal film layer (76) are sequentially layered after the gate insulator film formation step;
   a second photolithography step, in which the source/drain metal film layer (76), the contact metal film layer (75), and the doped silicon semiconductor film layer (74) doped with impurities, which have been layered in the second layering step, and the intrinsic silicon semiconductor film layer (3) are sequentially etched with photolithography using a second resist pattern (77), forming the TFTs (78), the second comb-shaped pixel electrode portions (80) and the first comb-shaped pixel electrode portions (79).

Here, it is possible to use an anodization process in the oxide film formation step of this manufacturing method.

Furthermore, intrinsic silicon semiconductor film layer (3) can be an intrinsic amorphous silicon film layer that has not been doped with impurities, and the doped silicon semiconductor film layer (74) can be an n-type doped amorphous silicon film layer that has been doped with n-type impurities.

Furthermore, the second comb-shaped pixel electrode portions (80) can be formed with the same layering structure as the layering structure including the layers on the source region including the silicon semiconductor film layer.

Furthermore, in the second layering step, the contact metal film layer (75) and the source/drain metal film layer (76) can be formed of the same material and in a single layer.

Furthermore, in the first layering step, an undercoat film can be formed between the insulating substrate (1) and the silicon semiconductor film.

With the above-described method for manufacturing an in-plane switching TFT array substrate, it is possible to manufacture, for example, TFT array substrates with the following structure.
i) an in-plane switching TFT array substrate, wherein the gate electrode metal-oxide film (72) and the first pixel electrode oxide film (72') are anodized films, in which the surface of electrode metal has been oxidized by anodization;
ii) an in-plane switching TFT array substrate, wherein the channel region of the silicon semiconductor film is made of an intrinsic silicon semiconductor film (3') not doped with impurities, and the source region and the drain region are made of two layers including the intrinsic silicon semiconductor film (3') not doped with impurities and a doped silicon semiconductor film (74') doped with impurities;
iii) an in-plane switching TFT array substrate, wherein the doped silicon semiconductor film (74') directly covers a lateral surface of the gate electrode metal-oxide film (72);
iv) an in-plane switching TFT array substrate, wherein contact electrodes (75') are disposed between the doped silicon semiconductor film (74') and the source electrode (76'), and between the doped silicon semiconductor film (74') and the drain electrode (76"); and
v) an in-plane switching TFT array substrate, wherein the second comb-shaped pixel electrode portions (80) are formed over the insulating substrate (1) at portions where the TFTs (78) and the first comb-shaped pixel electrode portions (79) are not formed, and include a silicon semiconductor film layer of the same material as at least the silicon semiconductor film and a metal film layer of the same material as the source electrode (76'), layered on top of one another.

### [6] Invention relating to an in-plane switching liquid crystal display device

### (A) using an in-plane switching TFT array substrate (A)

An in-plane switching liquid crystal display device, wherein, on a surface of an in-plane switching TFT array substrate including first comb-shaped pixel electrode portions (79), second comb-shaped pixel electrode portions (80) serving as opposing electrodes, and TFTs (78) driving the first comb-shaped pixel electrode portions (79), arranged in a matrix on an insulating substrate (1), a first substrate, provided with a liquid crystal alignment film, and a second substrate including at least a color filter are arranged in opposition to one another with the pixel electrode and the color filter facing inward, and a liquid crystal is injected into a gap between the two substrates;
the TFTs (78) including:
   a silicon semiconductor film deposited over an insulating substrate (1);
   a gate insulator film (73) formed over a channel region of the silicon semiconductor film;
   a gate electrode (71) formed over the gate insulator film (73);
   a gate electrode metal-oxide film (72) covering the surface of the gate electrode (71);
   a source electrode (76') covering at least a lateral surface of the gate electrode metal-oxide film (72) on the source region side and a source region; and
   a drain electrode (76") covering at least a lateral surface on the drain region side of the gate electrode metal-oxide film (72) and a drain region, the source electrode (76') and the drain electrode (76") being separated from one another at an upper surface of the gate electrode metal-oxide film (72);
   wherein the first comb-shaped pixel electrode portions (79) are formed at a part of the substrate where the TFTs (78) are not formed, and include:
   a first pixel silicon semiconductor film (3") deposited over the insulating substrate (1);
   a first pixel insulator film (73') formed over the first pixel silicon semiconductor film (3");
   a first pixel electrode (71') formed over the first pixel insulator film (73'); and
a first pixel electrode oxide film (72') covering an upper surface and a lateral surface of the first pixel electrode (71').

In this configuration, the gate electrode metal-oxide film (72) and the first pixel electrode oxide film (72') can be anodized films, in which the surface of electrode metal has been oxidized by anodization.

Furthermore, the structure of the second comb-shaped pixel electrode portions (80) can be the same as the layering structure of the layers on the source region including the silicon semiconductor film layer.

Furthermore, a protective film can be disposed between a surface of the in-plane switching TFT array substrate and the liquid crystal alignment film.

It should be noted that the operational effects when employing the above configuration are the same as explained for the configurations of the other aspects of the invention.

### [7] Invention relating to an in-plane switching TFT array substrate (B)

Here, when it is necessary to differentiate between the above-described in-plane switching TFT array substrate and the in-plane switching TFT array substrate described in this section, the above-described substrate is referred to as the in-plane switching TFT array substrate (A), where as the array substrate described in this section is referred to as the in-plane switching TFT array substrate (B).

An in-plane switching TFT array substrate includes first comb-shaped pixel electrode portions (104), second comb-shaped pixel electrode portions (103) serving as opposing electrodes, and TFTs (78) driving the first comb-shaped pixel electrode portions, arranged in a matrix on an insulating substrate (1);
the TFTs (78) including:
   a silicon semiconductor film deposited over an insulating substrate (1);
   a gate insulator film (73) formed over a channel region of the silicon semiconductor film;
   a gate electrode (71) formed over the gate insulator film (73);
   a gate electrode metal-oxide film (72) covering the surface of the gate electrode (71);
   a source electrode (76') covering at least a lateral surface of the gate electrode metal-oxide film (72) on the source region side and a source region; and
   a drain electrode (76") covering at least a lateral surface on the drain region side of the gate electrode metal-oxide film (72) and a drain region, the source electrode (76') and the drain electrode (76") being separated from one another at an upper surface of the gate electrode metal-oxide film (72);
   wherein the first comb-shaped pixel electrode portions (104) are formed at a part of the substrate where the TFTs (78) are not formed;
   wherein a surface of the TFTs (78) and the first comb-shaped pixel electrode portions (104) is covered by a protective film (101); and
   wherein the second comb-shaped pixel electrode portions (79) are formed on the protective film (101) at a part of the substrate where the TFTs (78) and the first comb-shaped pixel electrode portions (104) are not formed.

An in-plane switching TFT array substrate (B) with this configuration can be manufactured for example by the following manufacturing method.

Such a method for manufacturing an in-plane switching TFT array substrate includes:
TFTs (78) including:
   a silicon semiconductor film deposited over an insulating substrate (1);
   a gate insulator film (73) formed over a channel region of the silicon semiconductor film;
   a gate electrode (71) formed over the gate insulator film (73);
   a gate electrode metal-oxide film (72) covering the surface of the gate electrode (71);
   a source electrode (76') covering at least a lateral surface of the gate electrode metal-oxide film (72) on the source region side and a source region; and
   a drain electrode (76") covering at least a lateral surface on the drain region side of the gate electrode metal-oxide film (72) and a drain region, the source electrode (76') and the drain electrode (76") being separated from one another at an upper surface of the gate electrode metal-oxide film (72);
first comb-shaped pixel electrode portions (104) formed at a part of the substrate where the TFTs (78) are not formed;
a protective film (101) covering a surface of the substrate including the TFTs (78) and the first comb-shaped pixel electrode portions (104);
second comb-shaped pixel electrode portions (103) formed at a part of the substrate where the TFTs (78) and the first comb-shaped pixel electrode portions (104) are not formed, and formed on the protective film (101);
the method including:
a first layering step, in which an intrinsic silicon semiconductor film layer (3) not doped with impurities, a gate insulator film layer (4), and a gate metal film layer (5) are sequentially layered over the insulating substrate (1);
a first photolithography step, in which the gate metal film layer (5) is etched with photolithography using a first resist pattern (100), forming the gate electrode (71) and a gate metal wiring pattern electrically connected thereto;
a metal-oxide film formation step, in which the surfaces of the gate electrode (71) and the gate metal wiring pattern are oxidized to form the gate electrode metal-oxide film (72) that covers the upper and lateral surface of the gate electrode (71) and the gate metal wiring oxide film that covers the upper and lateral surface of the gate metal wiring pattern;
an insulator film formation step, in which the gate insulator film layer (4) is etched, with the oxide film as a mask, forming the gate insulator film (73);
a second layering step, in which a doped silicon semiconductor film layer (74) doped with impurities, a contact metal film layer (75), and a source/drain metal film layer (76) are sequentially layered after the gate insulator film formation step;
a second photolithography step, in which the source/drain metal film layer (76), the contact metal film layer (75), and the doped silicon semiconductor film layer (74) doped with impurities, which have been layered in the second layering step, and the intrinsic silicon semiconductor film layer (3) not doped with impurities are sequentially etched with photolithography using a second resist pattern (102), forming the TFTs (78) and the first comb-shaped pixel electrode portions (104);
a protective film deposition step, in which, after the second photolithography step, a protective film (101) is deposited, covering a surface of the TFTs (78) and the first comb-shaped pixel electrode portions (104) formed on the substrate surface;
a metal film deposition step, in which a metal film layer for forming the second comb-shaped pixel electrode is deposited on the protective film (101);
a second comb-shaped pixel electrode forming third photolithography step of etching the metal film layer with photolithography using a third resist pattern (106), forming second comb-shaped pixel electrodes (103) serving as opposing electrodes, the second comb-shaped pixel electrode forming third photolithography step being performed after the metal film deposition step.

In this method for manufacturing an in-plane switching TFT array substrate, the oxidation method in the metal-oxide film formation step can be anodization.

Furthermore, the intrinsic silicon semiconductor film layer (3) can be an intrinsic silicon semiconductor film layer not doped with impurities, and the doped silicon semiconductor film layer (74) can be an n-type doped amorphous silicon film layer that has been doped with n-type impurities.

Furthermore, the first comb-shaped pixel electrode portions (104) can be formed with the same layering structure as the layering structure on the drain region including the silicon semiconductor film layer.

Furthermore, in the second layering step, the contact metal film layer (75) and the source/drain metal film layer (76) can be formed of the same material and in a single layer.

Furthermore, in the first layering step, an undercoat film can be formed between the insulating substrate (1) and the silicon semiconductor film.

With the above-described method for manufacturing an in-plane switching TFT array substrate, it is possible to manufacture, for example, in-plane switching TFT array substrates with the following structure.
i) an in-plane switching TFT array substrate, wherein the gate electrode metal-oxide film (72) is an anodized film, in which the surface of electrode metal has been oxidized by anodization.
ii) an in-plane switching TFT array substrate, wherein the first comb-shaped pixel electrode portions (104) are formed with the same layering structure as the layering structure including the silicon semiconductor film layer on the source region.
iii) an in-plane switching TFT array substrate, wherein the second comb-shaped pixel electrode portions (103) are made of the same metal as the source electrode (76').
iv) an in-plane switching TFT array substrate, wherein the intrinsic silicon semiconductor film layer (3) is an intrinsic silicon semiconductor film layer not doped with impurities, and wherein the doped silicon semiconductor film layer (74) is an n-type doped amorphous. silicon film layer that has been doped with n-type impurities.

### [8] Invention relating to an in-plane switching liquid crystal display device

### (B) using an in-plane switching TFT array substrate (B)

An in-plane switching liquid crystal display device, wherein, on a surface of an in-plane switching TFT array substrate including first comb-shaped pixel electrode portions (104), TFTs (78) driving the first comb-shaped pixel electrode portions, and second comb-shaped pixel electrode portions (103) serving as opposing electrodes formed on a silicon protective film covering a surface of at least the first comb-shaped pixel electrode portions (104) and the TFTs (78), a first substrate, provided with a liquid crystal alignment film and a second substrate including at least a color filter are arranged in opposition to one another with the pixel electrode and the color filter facing inward, and a liquid crystal is injected into a gap between the two substrates;
the TFTs (78) comprising:
   a silicon semiconductor film deposited over an insulating substrate (1);
   a gate insulator film (73) formed over a channel region of the silicon semiconductor film;
   a gate electrode (71) formed over the gate insulator film (73);
   a gate electrode metal-oxide film (72) covering the surface of the gate electrode (71);
   a source electrode (76') covering at least a lateral surface of the gate electrode metal-oxide film (72) on the source region side and a source region; and
   a drain electrode (76") covering at least a lateral surface on the drain region side of the gate electrode metal-oxide film (72) and a drain region, the source electrode (76') and the drain electrode (76") being separated from one another at an upper surface of the gate electrode metal-oxide film (72);
      wherein the first comb-shaped pixel electrode portions (104) are formed at a part of the substrate where the TFTs (78) are not formed,
      wherein a surface of the TFTs (78) and the first comb-shaped pixel electrode portions (104) is covered by a protective film (101); and
      wherein the second comb-shaped pixel electrodes (79) are formed on the protective film (101) at a part of the substrate where the TFTs (78) and the first comb-shaped pixel electrode portions (104) are not formed.

In this configuration, the gate electrode metal-oxide film (72) and the first pixel electrode oxide film (72') can be anodized films, in which the surface of electrode metal has been oxidized by anodization.

Furthermore, the structure of the first comb-shaped pixel electrode portions (104) can be the same as the layering structure of the layers on the source region including the silicon semiconductor film layer.

Furthermore, a second protective film is disposed between a surface of the in-plane switching TFT array substrate and the liquid crystal alignment film.

It should be noted that the operational effects when employing the above configuration are the same as explained for the configurations of the other aspects of the invention.

### BRIEF DESCRIPTION OF THE DRAWINGS

Fig. 1 is a cross-sectional diagram of a TFT array substrate illustrating the manufacturing processes according to Working Example 1 of the present invention.
Fig. 2 is a cross-sectional diagram of a TFT array substrate illustrating the manufacturing processes according to Working Example 1 of the present invention.
Fig. 3 is a cross-sectional diagram of a TFT array substrate illustrating the manufacturing processes according to Working Example 1 of the present invention.
Fig. 4 is a cross-sectional diagram of a liquid crystal display device according to Working Example 2 of the present invention.
Fig. 5 is a cross-sectional diagram of a TFT array substrate illustrating the manufacturing processes according to Working Example 3 of the present invention.
Fig. 6 is a cross-sectional diagram of a TFT array substrate illustrating the manufacturing processes according to Working Example 4 of the present invention.
Fig. 7 is a cross-sectional diagram of a TFT array substrate illustrating the manufacturing processes according to Working Example 5 of the present invention.
Fig. 8 is a cross-sectional diagram of a TFT array substrate illustrating the manufacturing processes according to Working Example 5 of the present invention.
Fig. 9 is a planar diagram of an in-plane switching TFT array substrate according to Working Example 5 of the present invention.
Fig. 10 is a cross-sectional diagram of a TFT array substrate illustrating the manufacturing processes according to Working Example 7 of the present invention.
Fig. 11 is a cross-sectional diagram of a TFT array substrate illustrating the manufacturing processes according to Working Example 7 of the present invention.
Fig. 12 is a planar diagram illustrating the process for forming input/output terminals by taking a protective film as the mask.

### BEST MODE FOR CARRYING OUT THE INVENTION

The following is a more specific description of the present invention, with reference to the preferred embodiments.

### Working Example 1

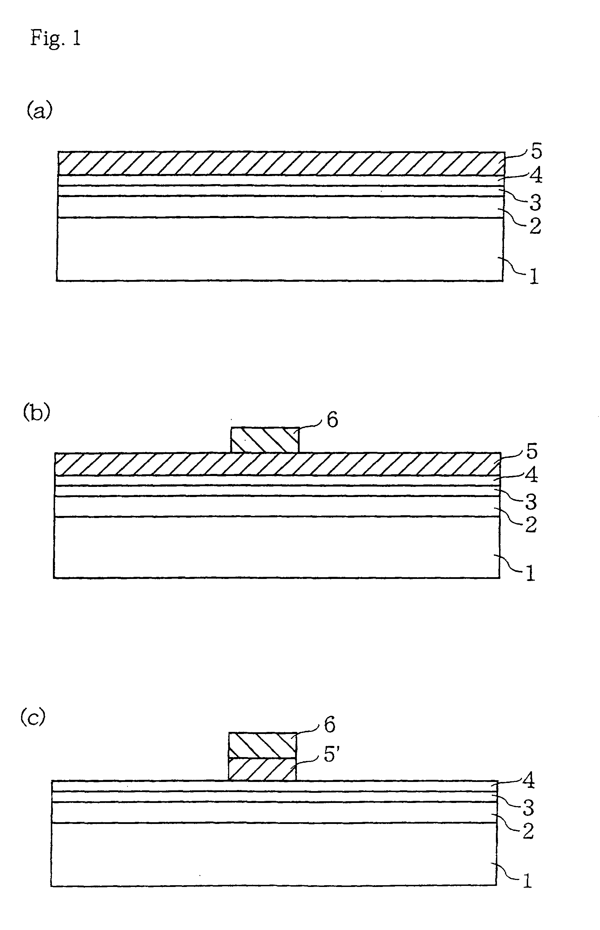

A SiO₂ film was deposited by CVD at a thickness of 400nm as an undercoat film 2 on the surface of an insulating substrate 1, which was made from a well-cleaned transparent glass substrate. Next, an intrinsic amorphous silicon film (a-Si film) not doped with impurities was deposited at a thickness of 50nm using plasma CVD, as an intrinsic silicon semiconductor film layer 3 not doped with impurities. After that, a SiNx film was deposited at a thickness of 150nm by plasma CVD to serve as a gate insulator film layer 4. An Al-Zr metal film made of an Al-Zr (97:3) alloy was subsequently deposited at a film thickness of about 200nm by sputtering in order to serve as a gate metal film layer 5 for the gate electrode and gate metal wiring (Fig. 1a). These operations were conducted consecutively within a vacuum.

Next, using a regular method, on top of the gate metal film layer 5, a first resist pattern 6 (Fig. 1b) for a first photolithography was formed using a first photomask, the gate metal film layer 5 was selectively etched, and a gate electrode 5' (Fig. 1c), and a gate metal wiring pattern (not shown in the drawings) connected to the gate electrode 5' were formed. Next, after the first resist pattern 6 was removed, the substrate was immersed in an approximately pH 7 electrolyte prepared using ammonium borate, the surface (upper and lateral surface) of the gate electrode 5' and the gate metal wiring were anodized by a process in which a current was sent through the gate metal wiring (hereafter called "anodization process"), and the surface of the gate electrode 5' and the gate metal wiring were covered with an insulating metal-oxide film whose primary component is Al₂O₃.

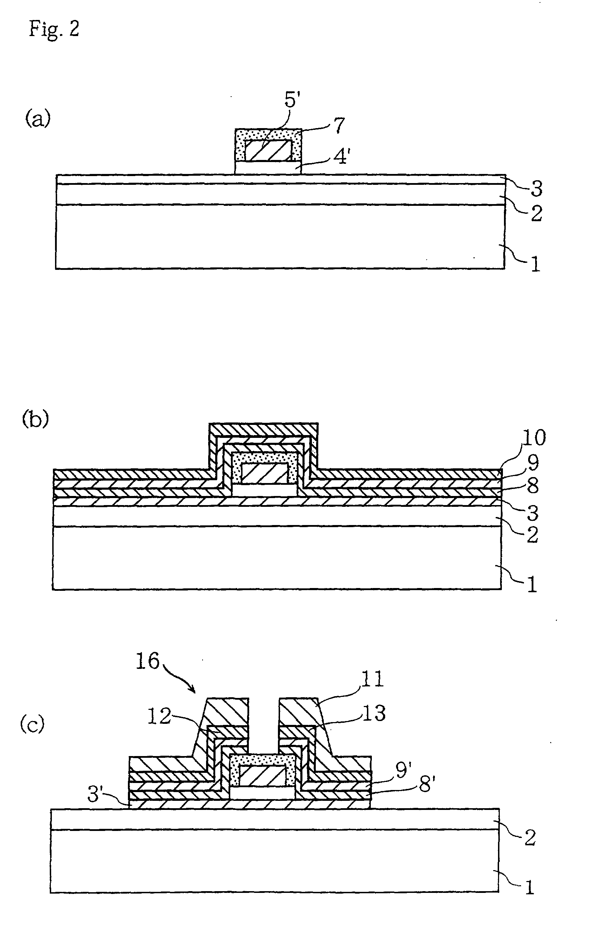

Subsequently, with the gate electrode metal-oxide film 7 formed on the surface of the gate electrode 5' as a mask, the gate insulator film layer 4 (SiNx film) was etched to form a gate insulator film 4' (Fig. 2a).

Subsequently, amorphous silicon (n⁺ a-Si) including phosphorous, which is an n-type impurity, was deposited on the substrate at a thickness of 50nm using plasma CVD, as a doped silicon semiconductor film layer 8 that has been doped with impurities. Next, a roughly 100nm thick Ti metal film was vapor deposited using sputtering, as a contact metal film layer 9. Then, an Al-Zr metal film made from an Al-Zr alloy was vapor deposited to a thickness of 200nm, as a source/drain metal film layer 10 (Fig. 2b).

Next, on top of the source/drain metal film layer 10, a resist pattern 11 for a second photolithography was formed using a second photomask. With the resist as the mask, the source/drain metal film layer 10, the contact metal film layer 9, the doped silicon semiconductor film layer 8, and the intrinsic silicon semiconductor film layer 3 were etched in that order to form a TFT, which included a source electrode 12 and a drain electrode 13, both made from the Al-Zr metal film, source/drain metal wiring connected to these, a contact electrode 9' made from the Ti metal film, source and drain regions made from the two layers of a doped silicon semiconductor film 8' and an intrinsic silicon semiconductor film 3' not doped with impurities, and a channel region made from the intrinsic silicon semiconductor film 3' (Fig. 2c).

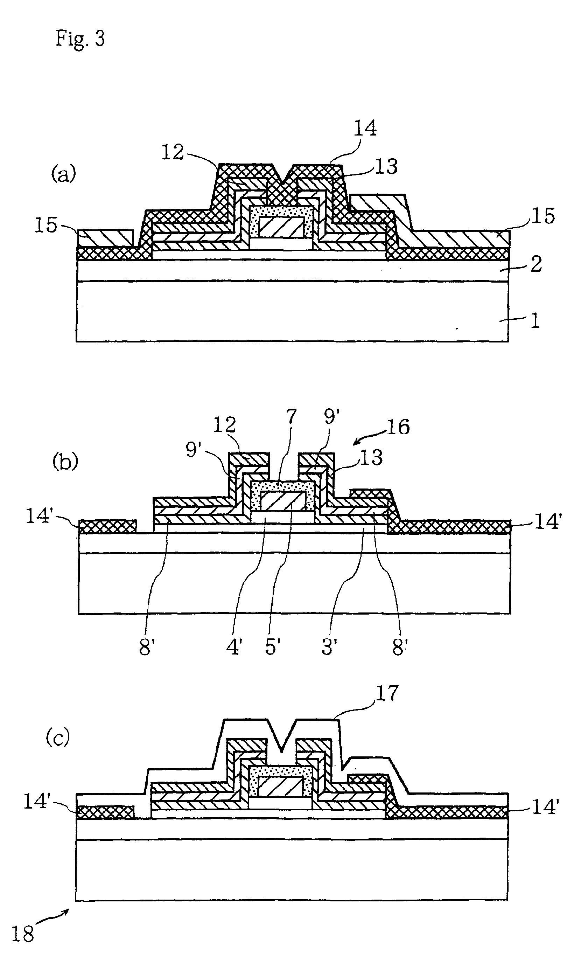

After this, an indium tin oxide film layer 14 for the transparent electrodes was layered to a film thickness of about 100nm using sputtering. On top of this, using a regular method, a third resist pattern 15 (Fig. 3a) for a third photolithography was formed using a third photomask. With this resist as a mask, the indium tin oxide film layer 14 was etched to form a transparent pixel electrode 14' (Fig. 3b).

Subsequently, a 300nm thick protective film layer 17 covering the TFT 16 and the pixel electrode 14', was formed by printing and baking using a silazane-based pyrolytic silica (Fig. 3c). With the silica protective film layer 17 as a mask, the metal-oxide film on the surface of the source/gate metal wiring around the substrate was etched away, thereby forming input/output terminals for connection with an exterior driving circuit.

Thus, a TFT array substrate 18 with the structure shown in Fig. 3c was manufactured. With this manufacturing method, a TFT array substrate suitable for a transparent liquid crystal display device can be manufactured with three photomasks.

In this manufacturing method, the surface (upper and lateral surface) of the gate electrode and the gate metal wiring was oxidized by an anodization process, and by this method the surface of the gate electrode and gate metal wiring could be reliably and effectively covered with an insulating film. Furthermore, in this manufacturing method, the gate electrode metal-oxide film 7 formed by an anodization process served as a mask to etch the gate insulator film layer 4 and form the gate insulator film 4', and with this method, no undercut portion was created underneath the gate electrode metal-oxide film 7.

It is also possible to form the gate insulator film 4' by a method in which the resist pattern 6, the gate electrode 5' and the gate metal wiring serve as a mask to etch the gate insulator film layer 4, prior to the formation of the gate electrode metal-oxide film 7, and then anodize the gate electrode 5' and the gate metal wiring. With this method, however, an undercut portion is created underneath the gate electrode metal-oxide film 7, because the anodization expands the metal film.

In the TFT array substrate of Working Example 1, the layer including the source electrode and the source metal wiring (hereafter referred to as "source wiring layer") has a triple layer structure of the semiconductor film (n⁺ a-Si film), the contact electrode (Ti metal film) and the source/drain metal film (Al-Zr metal film) serving as the source metal wiring. With this structure, the source wiring resistance can be reduced in comparison to a source wiring layer with a one-layer structure of only the source metal wiring.

Additionally, in the TFT array substrate of Working Example 1, the withstand voltage between the gate electrode and the drain electrode is high, because the TFT array substrate has a structure, in which two layers, namely the gate electrode metal-oxide film 7 and the doped silicon semiconductor film (n⁺ a-Si film) 8', are arranged between the gate electrode 5' and the contact electrode 9'. Furthermore, in this structure, a contact electrode 9' made of a Ti metal film is disposed between the source and drain electrodes 12 and 13 (Al-Zr metal film) and the doped silicon semiconductor film 8', and the contact electrode 9' suppresses migration of the Al within the Al-Zr metal film to the channel layer. Therefore, with this structure, degradation of the transistor properties resulting from contamination with Al can be prevented.

Furthermore, the source metal wiring and the gate metal wiring are separated by the insulating metal-oxide film and the n⁺ a―Si film, so that the withstand voltage between the gate metal wiring and the source metal wiring is excellent.

Also, according to the manufacturing method of Working Example 1, it is not necessary to perform an impurity diffusion step to form the source and drain regions, because in all parts except the channel region, a doped silicon semiconductor film (n⁺ a―Si) is layered on an intrinsic silicon semiconductor film (intrinsic a―Si film; this can also be an intrinsic low-temperature polysilicon film). Additionally, the n⁺ a―Si film on the gate electrode can be easily removed by etching until the oxide film on the surface of the gate electrode is reached, so that this manufacturing method makes it possible to reduce production costs of the n-channel TFT array substrate.

Furthermore, in the aforementioned manufacturing method, the undercoat film (2) is formed onto the surface of the glass substrate (1), and on top of the undercoat film, the semiconductor film (intrinsic a―Si film) and the gate insulator film are formed consecutively, thus making it possible to configure a channel part with a low occurrence of interfaces states. Thus the TFT achieves excellent drive stability, because the undercoat film prevents impurities within the glass substrate from diffusing toward the semiconductor film (3).

In the aforementioned fabrication process, if the source metal wiring and the contact electrode are of the same material, such as a Ti metal film, and are made to form a single layer, the number of process steps can be further reduced.

### Working Example 2

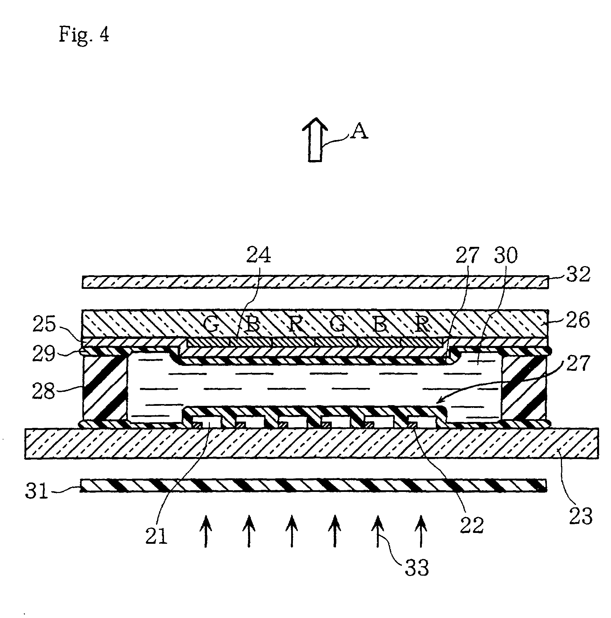

The Working Example 2 relates to a liquid crystal display device using a TFT array substrate produced in a manner similar to Working Example 1. A cross section outlining a device according to Working Example 2 is shown in Fig. 4. First, in a manner similar to that of Working Example 1, three masks were used to manufacture a TFT array substrate (a first substrate 23) that includes a first transparent pixel electrode group 21, a transistor group 22 that drives these electrodes, and a silica protective film 17 (not shown in Fig. 4) covering these components. Note that this TFT array substrate is substantially the same as the TFT array substrate 18 of Working Example 1.

On the other side, as an opposing substrate, a second substrate 26 including, on top of a glass substrate, a color filter group 24, a second transparent electrode (common electrode) 25, and a protective film 17 (a silica protective film or a silicon nitride protective film are suitable for this protective film) were formed by conventional methods.

Then, a polyimide resin was applied to the surfaces of the first and the second substrates, and heat-cured to form coating films. The surface of these coating films was rubbed in a certain direction to make liquid crystal alignment films 27. The first substrate 23 and the second substrate 26 were then positioned such that their electrodes were in opposition, and arranged such that the alignment orientation of the liquid crystal was twisted for 90°, and an empty cell that maintained a gap of about 5µm with spacers 28 and a sealant 29 was produced. A TN liquid crystal (ZLI14792; manufactured by Merck Ltd.) 30 was injected into the gap of this empty cell and the cell's open port was sealed, after which polarizers 31 and 32 were disposed in a cross-nicol arrangement on both outer sides of the cell, and thus the transparent liquid display device illustrated in Fig. 4 was accomplished.

It was found that when driving the transistors with a video signal while illuminating the entire surface of the substrate 23 with a backlight 33, disposed on the outer side of this device, it was possible to display a sharp color image in the direction of the arrow A.

An inorganic silica film or silicon nitride film is suitable as the material for the protective film. In particular, it is convenient to use a sol-gel silica-based inorganic material, because the silica film can be selectively formed by printing. It is of course also possible to form the liquid crystal alignment film directly on the surface of the TFTs without providing a protective film.

### Working Example 3

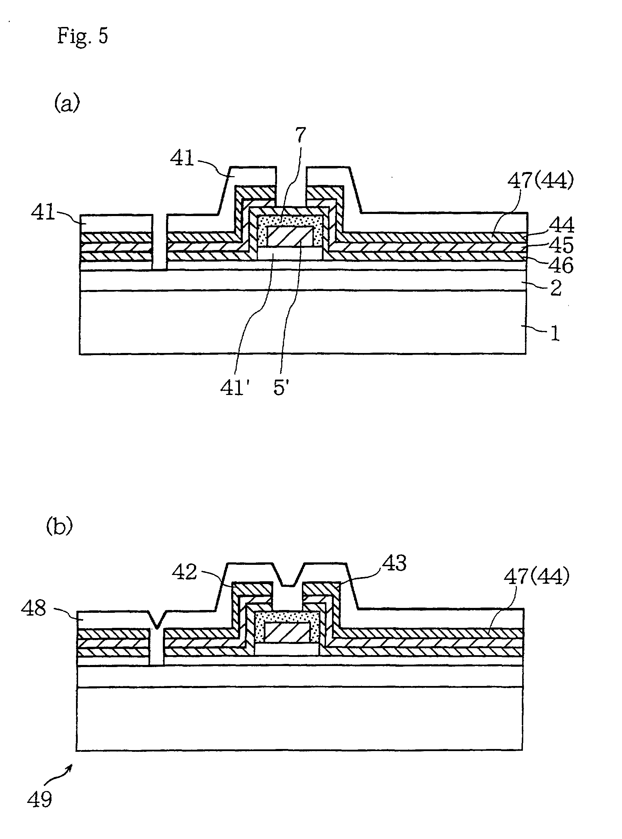

In Working Example 3, a reflective liquid crystal display device was produced by a manufacturing method using two masks. In the method for manufacturing the reflective liquid crystal display device according to Working Example 3, the steps for forming deposition layers in sequence on the glass substrate, that is, the steps illustrated in Figs. 1a to 1c and Figs. 2a and 2b, were conducted similarly to Working Example 1. Thus, further explanations of these steps will be omitted, and the explanations will focus on Figs. 5a and b (the steps after Fig 2 b), which differ from Working Example 1. Elements that are similar to those in Working Example 1 are given identical numbers and are also omitted from the explanation.

In Working Example 1, a source electrode, a drain electrode, source metal wiring and drain metal wiring were formed from the source/drain metal film layer 10 of Fig. 2b, but in Working Example 3, not only is the source electrode, etc. formed from the source/drain metal film layer 10, but also a reflective pixel electrode is formed therefrom. A more specific description follows below.

A photolithography resist was applied on top of the source/drain metal film layer 10 of Fig. 2b and a second photolithography resist pattern 41 was formed (Fig. 5a), and with this resist as a mask, the source/drain metal film layer (Al-Zr metal film) 10, the contact metal film layer (Ti metal film) 9, the doped silicon semiconductor film layer (n⁺ a-Si film) 8, and the intrinsic silicon semiconductor film layer (intrinsic a-Si film) 3 were sequentially etched to form a group of reflective pixel electrodes and TFTs (Fig. 5b), including a source electrode 42 made from the Al-Zr metal film, a drain electrode / reflective pixel electrode 43 / 47, in which the drain electrode and the reflective pixel electrode are formed as one, source/drain metal wiring (not shown in the drawings) connected thereto, a contact electrode 44 made from the Ti metal film, a source and a drain region of a two layer structure of a doped silicon semiconductor film 45 and an intrinsic silicon semiconductor film 46, and a channel region made from the intrinsic silicon semiconductor film 46.

Next, by printing and baking using a silazane-based pyrolytic silica, a 300nm thick silica protective film 48 was formed such that it covered the TFT group and the reflective pixel electrode group 47 (43). With this silica protective film pattern as a mask, that portion of the anodized film on the metal film for the gate electrode that is in contact with the exterior driving circuit was etched away. This completed a TFT array substrate 49 (Fig. 5b) that can be used in a reflective liquid crystal display device.

In the present working example, the source electrode, the gate electrode, the source metal wiring, the gate metal wiring, and the reflective pixel electrode were formed from a single deposition layer made of the same material. Therefore, in comparison to Working Example 1, it was possible to further reduce the number of masks by one and to manufacture a liquid crystal display device with a total of two masks.

Furthermore, in the present working example, the reflective pixel electrode was formed by an Al-Zr metal film, which is preferable because an electrode made from an Al-Zr metal film has excellent reflective properties. The material for the reflective pixel electrode, however, is not limited to that of an Al-Zr metal film, and it is possible to use a variety of metals or alloys, that have conductive and reflective properties.

In the present working example, the source/drain metal film layer was an Al-Zr metal film layer, and the contact metal film layer was a Ti metal film layer, however, these layers can also be formed as a single layer of the same material. This further simplifies the film formation steps and the etching steps.

### Working Example 4

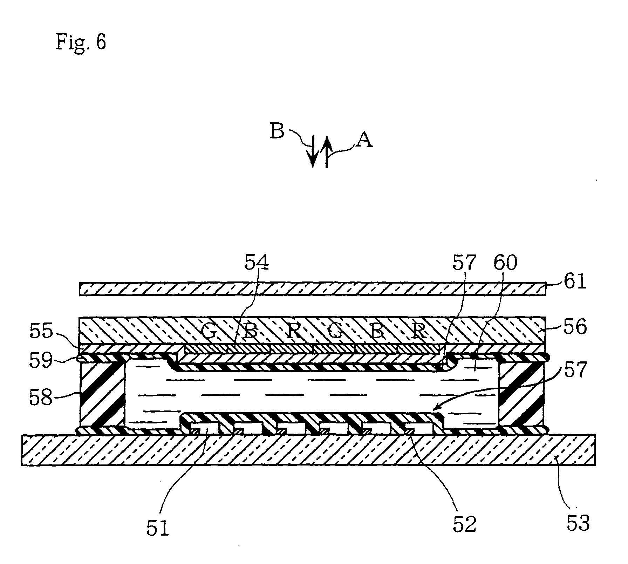

A reflective liquid crystal display device of the structure shown in Fig. 6 was manufactured using a reflective TFT array substrate of a structure similar to that of Working Example 3.

First, similar to Working Example 3, a first substrate 53 with a reflective electrode group 51 and a transistor group 52 that drives this electrode group arranged in a matrix was produced using two masks. On the other side, a second substrate 56, which includes a color filter group 54 and a transparent electrode 55, was produced by conventional methods to serve as an opposing electrode to the first TFT array substrate 53. Additionally, a polyimide resin was applied to the surfaces of the first and second substrates and heat-cured to make coating films. The surface of these coating films was rubbed in a certain direction to form liquid crystal alignments film 57.

The first substrate 53 and the second substrate 56 were arranged with their electrode surfaces facing inward, and maintaining a gap of about 5µm with spacers 58 and a sealant 59, an empty cell was configured, in which the alignment orientation of the liquid crystal was twisted for 90°. A TN liquid crystal (ZLI14792; manufactured by Merck Ltd.) 60 was injected into the gap of this empty cell, thus completing a liquid crystal display device. Then, a polarizer 61 was disposed to the outside of the second substrate 56, thereby accomplishing a reflective liquid display device.

An exterior driving circuit was connected to this reflective liquid crystal display device, and when the transistors were driven with a video signal, a sharp color image was displayed in the direction of the arrow A. In this device, light that has entered from the direction of the arrow B is reflected by the reflective electrode group 51 and returned in the direction of the arrow A. A silica protective film is interposed between the liquid crystal alignment film 57 on the first and second substrates and the electrodes. This silica protective film, however, has been omitted from Fig. 6.

### Working Example 5

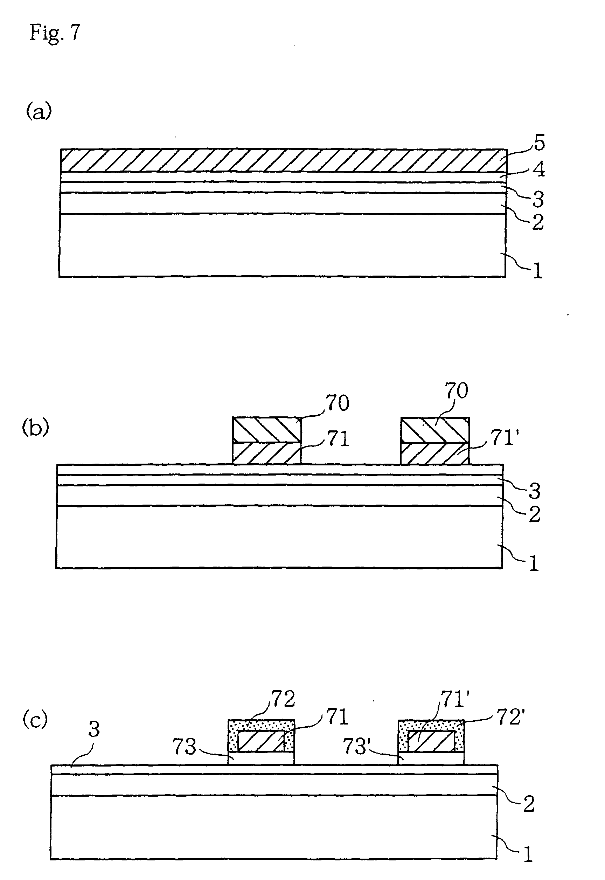

An in-plane switching (IPS) liquid crystal display device was manufactured in Working Example 5. The manufacturing method and structure of this device are explained with reference to Figs. 7 to 9. The step in Fig. 7a (step of forming deposition layers sequentially on the glass substrate) is similar to that in Fig. 1a of Working Example 1 in terms of the materials used and the manufacturing process.

Similar to Working Example 1, a SiO₂ film was deposited by CVD at a thickness of 400nm as an undercoat film 2 on the surface of an insulating substrate 1 made from a well-cleaned transparent glass substrate. Next, an intrinsic amorphous silicon film (intrinsic a―Si film) not doped with impurities was deposited as a semiconductor film layer 3 at a thickness of 50nm using plasma CVD. Furthermore, a SiNx film was deposited as a gate insulator film layer 4 at a thickness of 150nm by plasma CVD. An Al-Zr film made of an Al-Zr (97:3) alloy was subsequently deposited at a film thickness of about 200nm by sputtering in order to act as a gate metal film layer 5 for the gate electrode and the gate wiring (Fig. 7a). These operations were conducted consecutively within a vacuum.

Next, using a regular method, resist patterns 70 (Fig. 7b) for the first photolithography were formed on top of the gate metal film layer 5 using a photomask, and the gate metal film layer 5 was selectively etched using the resist patterns 70 and 70 for this photolithography, forming gate electrodes 71 and 71' (Fig. 7b) and a gate metal wiring pattern (not shown in the drawings). After the resist patterns 70 and 70 were removed, the substrate was immersed in an electrolyte with a pH of approximately 7 prepared using ammonium borate, and the surface (upper and lateral surface) of the gate electrodes 71 and 71' and the gate metal wiring was anodized by a process in which a current was sent through the gate metal wiring. Thus, because the upper and lateral surfaces of the gate electrodes 71 and 71' and the gate metal wiring were covered with gate electrode metal-oxide films 72 and 72' whose primary component is Al₂O₃, gate insulator films 73 and 73' were then formed by etching the gate insulator film layer 4 with the gate electrode metal-oxide films 72 and 72' as the mask (Fig. 7c).

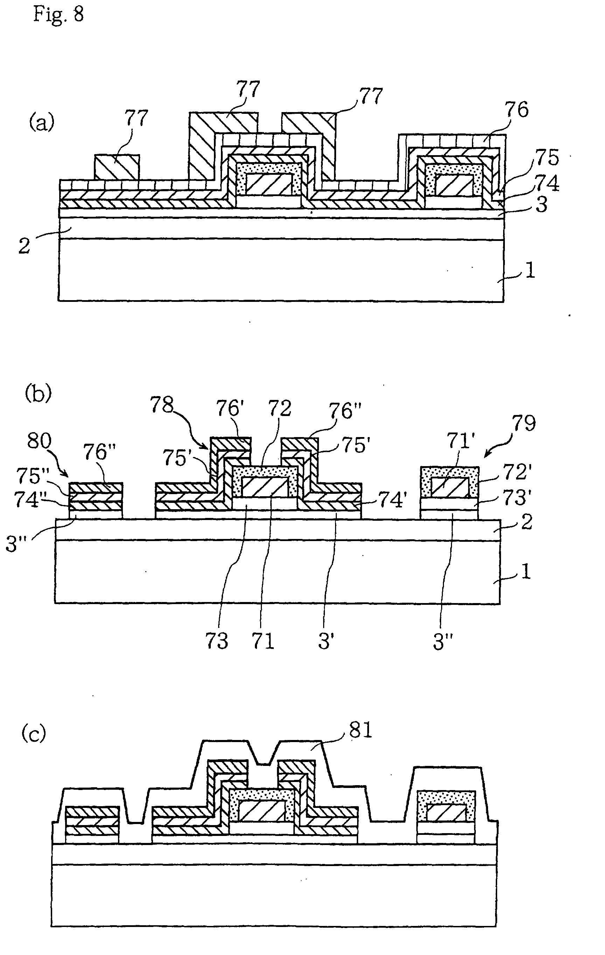

Subsequently, amorphous silicon containing phosphorous, which is an n-type impurity, was deposited using plasma CVD from above the gate electrode metal-oxide films 72 and 72' to form an n-type doped silicon semiconductor film layer 74 made of a 50nm thick n⁺ a―Si film, a Ti metal film was vapor deposited by sputtering to about 100nm as a contact metal film layer 75. Furthermore, an Al-Zr film made from an Al-Zr alloy was vapor deposited to a film thickness of 200nm as a source/drain metal film layer 76 (Fig. 8a).

Next, on top of the source/drain metal film layer 76, a resist pattern 77 for the second photolithography was formed using the second photomask. With this resist as the mask, the source/drain metal film layer 76, the contact metal film layer 75, the doped silicon semiconductor film layer 74, and the intrinsic silicon semiconductor film layer 3 were etched in that order. Thus, a TFT (78) was formed, which includes a source electrode 76' and a drain electrode 76", both made from the Al-Zr metal film, a source/drain metal wiring connected thereto, a contact electrode 75' made from the Ti metal film, a source/drain region with a two-layered structure of an intrinsic silicon semiconductor film 3' and a doped silicon semiconductor film 74', and a channel region made from the intrinsic silicon semiconductor film 3'. Furthermore, a first comb-shaped pixel electrode (79) including an intrinsic silicon semiconductor film 3", a gate insulator film 73', a gate electrode 71', and a gate electrode metal-oxide film 72', deposited in that order, and a second comb-shaped pixel electrode (80) with a four-layered structure including an intrinsic silicon semiconductor film 3''' (a―Si film), a doped silicon semiconductor film 74" (n⁺ a―Si film), a contact metal film 75" (Ti metal film), and a source/drain metal film 75''' (Al-Zr metal film), deposited in that order, were formed (Fig. 8b).

After this, a 300nm thick silica protective film 81 was formed (Fig. 8c), covering the TFT and the first and second comb-shaped pixel electrodes, by printing and baking using a silazane-based pyrolytic silica. With the silica protective film 81 acting as a mask, that part of the anodized film on the surface of the source/gate metal wiring that is connected to the exterior driving circuit was etched away.

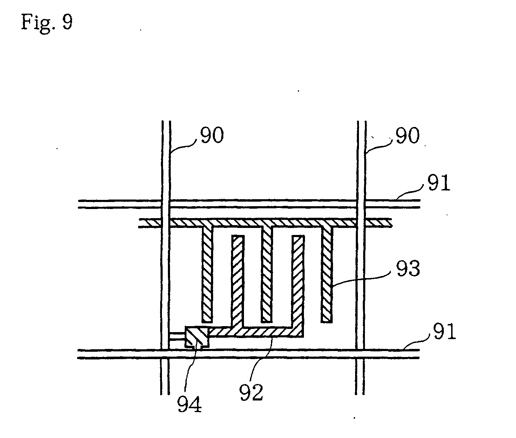

In this manner, a TET array was completed that can be used in an IPS liquid crystal display device. A schematic top view of this IPS TFT array substrate is shown in Fig. 9. In Fig. 9, numeral 90 denotes the source wiring, numeral 91 denotes the gate wiring, numeral 92 denotes the first comb-shaped electrode (pixel electrode), numeral 93 denotes the second comb-shaped electrode (common electrode), and numeral 94 denotes the TFT portion. With this manufacturing process, the IPS TFT array substrate of the structure illustrated in Fig. 7b and Fig. 9 can be manufactured with two photomasks.

The source wiring layer and the second comb-shaped pixel electrode layer in the present working example are made by layering two types of metal films: an Al-Zr metal film (source/drain metal film) and a Ti metal film (contact metal film). However, it is also possible to leave out the contact metal film and form the source electrode and the comb-shaped pixel electrodes from a single layer made of the same metal (such as an Al-Zr alloy film). By doing this, the manufacturing steps (vapor deposition or sputtering) can be reduced by one, and the productivity is further improved.

In the present working example, the surfaces of the gate electrode and the first comb-shaped pixel electrode are anodized simultaneously and their upper and lateral surfaces are covered with anodized film. With this method, the surface of the metal conductors can be productively covered with an insulating film, and a TFT array substrate can be produced that has little electric current leakage between the gate electrode and the first comb-shaped pixel electrode. Moreover, in the above manufacturing process, the first comb-shaped electrode portion is a four-layered structure of a semiconductor film layer, a gate insulator film layer, a gate metal film layer, and an anodized film layer, and because the height of the electrode is substantially the same as the height of the second comb-shaped electrode, an easy rubbing process and other advantageous effects are attained.

Furthermore, in the present working example, short circuits resulting from pin holes between the gate electrode and the drain electrode can be reduced considerably, because the two layers of the metal-oxide film and the semiconductor film are disposed between the gate electrode and the contact electrode. Additionally, because the source metal wiring intersects with the gate metal wiring and the second comb-shaped pixel electrode via the metal-oxide film and the semiconductor film, short circuits between wires are reduced significantly, resulting in a TFT array substrate with a high BT (bias temperature) reliability.

In the above working example (as in other working examples as well) a configuration was adopted in which the TFT, etc. is protected with a protective film, however, it is also possible to omit the protective film.

### Working Example 6

In Working Example 6, an IPS liquid crystal display device was produced using an IPS TFT array substrate produced using two photomasks, as in the above Working Example 5.

First, a polyimide resin was applied to the surface of an IPS TFT array substrate produced as in Working Example 5. This resin was heat-cured to make a coating film, and the surface of the coating film was rubbed to make a liquid crystal alignment film. This referred to as the first substrate.

On the other side, a group of color filters was provided on a glass substrate, and after a silica protective film was formed on top of the filters, a second substrate was by forming a liquid crystal alignment film as described above. The first and second substrates were arranged at a gap of about 5 micron gap by spacers and a sealant, and placed in opposition, positioning their alignment films such that the liquid crystal alignment orientation is twisted by 90°. After this, a nematic liquid crystal was injected into the cell gap (empty cell) and polarizers were arranged on the outer sides of the substrates in a cross-nicol arrangement, thus completing the IPS liquid crystal display device.

When the transistors were driven with a video signal while the entire surface of the first substrate was illuminated with a backlight disposed outside of the device, a sharp color image was displayed on the second substrate side. Furthermore, it was found that the viewing angle of this device at a contrast ratio of 10 was 160° vertically and horizontally, and that according to this working example, a liquid crystal display device with excellent viewing angle characteristics could be manufactured with high productivity.

### Working Example 7

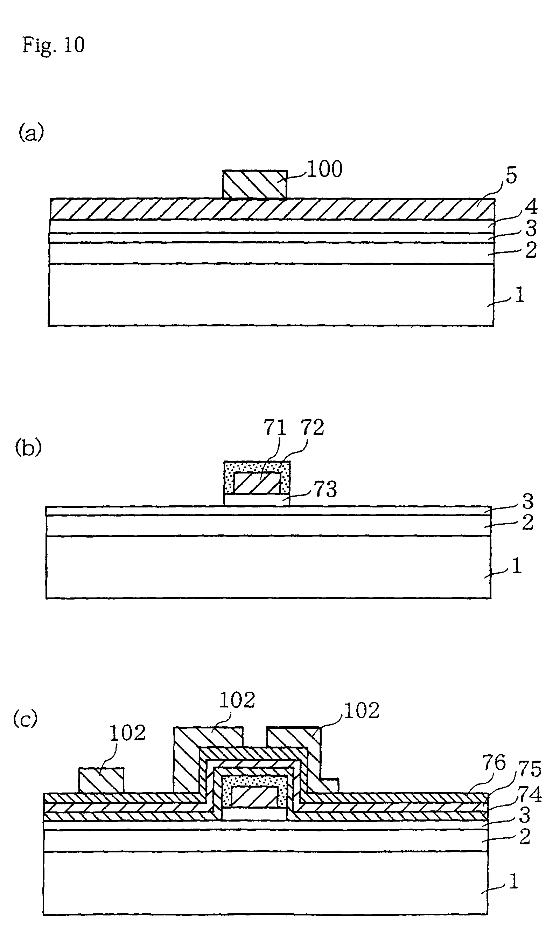

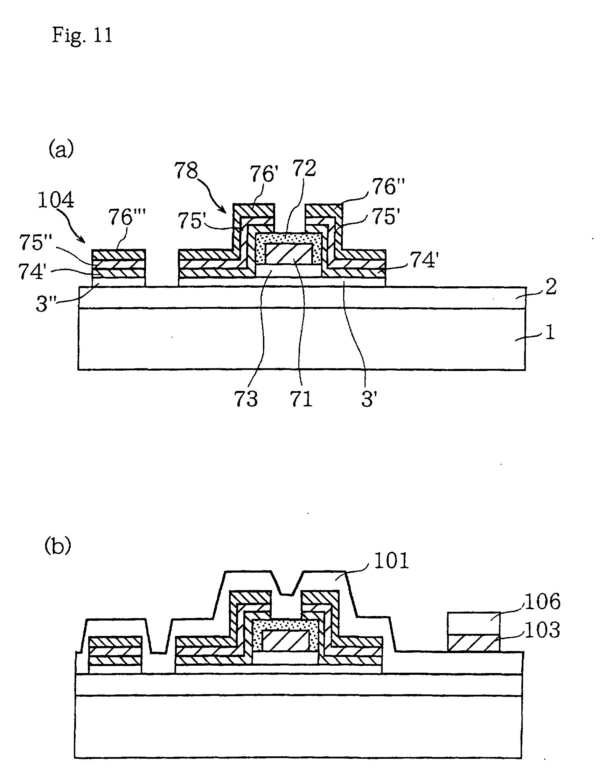

In Working Example 7, an IPS TFT array substrate was produced with a manufacturing process in which three photomasks are used. Working Example 7 is largely similar to Working Example 5, except that the structure of the first and second comb-shaped pixel electrodes is different. Therefore, parts similar to those in Working Example 6 are given the same numerals and their detailed explanation has been omitted. And, of the manufacturing processes of Working Example 7, the processes illustrated in Figs. 1a to c and Figs. 2a and b of Working Example 1 are the same as those of Working Example 1. The following explains a method for producing an IPS TFT array substrate of Working Example 7, with reference to Fig. 10 and Fig. 11.

Using an insulating substrate 1 on which an undercoat film 2, an intrinsic silicon semiconductor film layer 3, a gate insulator film layer 4, and a gate metal film layer 5, have been layered in that order, a gate electrode 71 was formed with photolithography using a first resist pattern 100, and with a procedure similar to that of Working Example 1, the surface (upper and lateral surfaces) of the gate electrode was anodized to form a gate electrode metal-oxide film 72. Then, a doped silicon semiconductor film layer 74, a contact metal film layer 75, and a source/drain metal film layer 76 were layered on the gate electrode metal-oxide film 72 (Fig. 10a to c). The details of these processes are similar to those explained for the processes in Figs. 1a to c and Fig. 2a of Working Example 1.

Next, a photolithographic resist was applied on top of the source/drain metal film layer 76 to form the second resist pattern 102, as shown in Fig. 10c. With this resist as a mask the source/drain metal film layer 76, the contact metal film layer 75, the doped silicon semiconductor film layer (n⁺ a―Si film) 74, and the intrinsic silicon semiconductor film layer (intrinsic a-Si film) 3 were etched in that order. Thus, a TFT and a first comb-shaped pixel electrode 104 were formed (Fig. 11a), the TFT including a source electrode 76' and a drain electrode 76" made of an Al-Zr metal film and respectively connected to source metal wiring and drain metal wiring, a contact electrode 75" made of a Ti metal film, source and drain regions with a two-layered structure of a doped silicon semiconductor film (n⁺ a―Si film) and an intrinsic silicon semiconductor film (intrinsic a―Si film), and a channel region made of an intrinsic silicon semiconductor film (intrinsic a―Si film), and the first comb-shaped pixel electrode 104 being a four-layered structure in which an intrinsic silicon semiconductor film 3"' (intrinsic a―Si film), a doped silicon semiconductor film 74" (n⁺ a―Si film), a contact metal film 75" (Ti metal film), and a source/drain metal film 76''' (Al-Zr film) have been layered in that order.

Subsequently, a silica protective film 101 covering the entire surface of the substrate was formed at a thickness of 300nm by printing and baking using a silazane-based pyrolytic silica, and an Al-Zr alloy film serving as a pixel electrode was deposited to about 100nm by sputtering on top of the silica protective film 101. Next, as the photomask process, photolithography was carried out with a third resist pattern 106 and the Al-Zr alloy film was etched to form a second comb-shaped pixel electrode 103 as the opposing electrode (Fig. 11b).

Furthermore, with the silica protective film 101 as a mask, the anodized film on top of that part of the gate electrode metal that is connected to the exterior driving circuit was etched away to form input/output terminals. Thus, an IPS TFT array substrate for a transparent liquid crystal display device was completed.

In the IPS TFT array substrate of Working Example 7, the first comb-shaped pixel electrode was formed on top of the silica protective film after the silica protective film had been formed, and with this structure, it is possible to achieve the effect of preventing current leaks and short circuits between the first comb―shaped pixel electrode and the second comb-shaped pixel electrode.

In this working example, the manufacturing process can be further simplified by forming the source electrode, the gate electrode, source/gate metal wiring, and the second comb-shaped pixel electrode with one layer made of the same material.

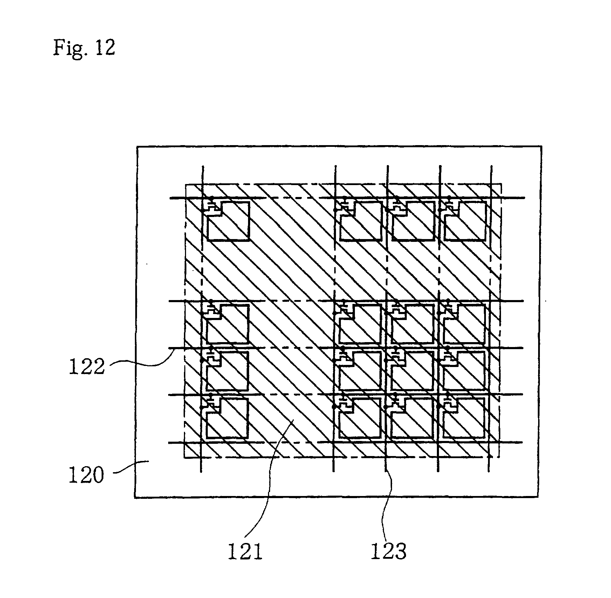

The following is an explanation of the process of covering a display pixel 121 portion on the TFT array substrate with the silica protective film, and etching away the metal-oxide film with this silica protective film as a mask to form input/output terminals. Fig. 12 illustrates a schematic diagram of the TFT array substrate. In Fig. 12, numeral 120 denotes a substrate, numeral 121 (hatched portion) denotes the region where the protective film is formed (display pixel portion), numeral 122 denotes the source wiring or the gate wiring, and numeral 123 denotes the gate wiring or the source wiring. As is clear from this diagram, when etching is carried out with the protective film as a mask, the anodized film on the surface of the metal wiring positioned outside the protective film region 121 is removed. That is, according to this method, the input/output terminals for connection to the exterior driving circuit can be formed without using a new mask.

### Working Example 8

A liquid crystal display device was produced using the IPS TFT array substrate of Working Example 7. This production method is similar to the one in Working Example 6, except that it uses the IPS TFT array substrate of Working Example 7 instead of the IPS TFT array substrate of Working Example 5, and so further explanations have been omitted.

When the IPS liquid crystal display device of Working Example 8 was driven with a video signal, a sharp color image with a wide viewing angle was displayed, similar to Working Example 6.

### INDUSTRIAL APPLICABILITY

As described above, according to the present invention, it is possible to simplify the TFT array substrate manufacturing process, and a TFT array substrate for a liquid crystal display device with a performance equivalent to conventional TFT array substrates can be manufactured using two or three photomasks. Therefore, the present invention contributes to a reduction in manufacturing costs for a TFT liquid crystal display device.

## Claims

1. A top gate TFT array substrate, in which pixel electrodes (14') and TFTs (16) driving the pixel electrodes are formed in a matrix on an insulating substrate (1); the TFTs comprising:
a silicon semiconductor film deposited over the insulating substrate (1);
a gate insulator film (4') formed over a channel region of the silicon semiconductor film;
a gate electrode (5') formed over the gate insulator film (4');
a gate electrode metal-oxide film (7) covering a surface of the gate electrode (5');
a source electrode (12) covering at least a lateral surface of the gate electrode metal-oxide film (7) on the source region side and a source region; and
a drain electrode (13) formed covering at least a lateral surface on the drain region side of the gate electrode metal-oxide film (7) and a drain region, the source electrode (12) and the drain electrode (13) being separated from one another at an upper surface of the gate electrode metal-oxide film (7);
wherein the pixel electrodes (14') are formed at parts of the substrate where the TFTs (16) are not formed, and the pixel electrodes (14') are electrically connected to the drain region of the silicon semiconductor film via the drain electrode (13).

2. The top gate TFT array substrate according to claim 1, wherein the gate electrode metal-oxide film (7) has been made by anodizing a surface of the gate electrode metal.

3. The top gate TFT array substrate according to claim 2, wherein the channel region of the silicon semiconductor film is made of an intrinsic silicon semiconductor film not doped with impurities, and wherein the source region and the drain region are made of a compound layer, in which a doped semiconductor film that has been doped with impurities is layered on the intrinsic silicon semiconductor film.

4. The top gate TFT array substrate according to claim 3, wherein contact electrodes (9') are disposed between the gate electrode metal-oxide film (7) and the source electrode (12), and between the gate electrode metal-oxide film (7) and the drain electrode (13); wherein the pixel electrode (14') is electrically connected to the drain region of the silicon semiconductor film via the drain electrode (13) and one of the contact electrodes (9'); and
wherein the source electrode (12) is electrically connected to the source region of the silicon semiconductor film via one of the contact electrodes (9').

5. The top gate TFT array substrate according to claim 4, wherein a doped silicon semiconductor film (8') is disposed between the gate electrode metal-oxide film (7) and the contact electrodes (9').

6. The top gate TFT array substrate according to claim 5,
wherein a surface of gate metal wiring electrically connected to the gate electrode (5') is covered by a gate metal-oxide film of oxidized gate metal; and
wherein the gate metal wiring and source metal wiring that is electrically connected to the source electrode (12) intersect via the gate metal-oxide film and the doped silicon semiconductor film deposited thereon.

7. The top gate TFT array substrate according to claim 6, wherein the source metal wiring electrically connected to the source electrode (12), and the contact electrodes (9'), are formed by patterning a metal film layer, which is made from a single layer of a single material deposited over the insulating substrate (1).

8. The top gate TFT array substrate according to claim 7, wherein the source wiring deposition layer including the source metal wiring is a three-layered structure made by sequentially layering a doped silicon semiconductor film, a contact metal film, and a source metal film.

9. The top gate TFT array substrate according to any of claims 3 to 8,
wherein the intrinsic silicon semiconductor film is an intrinsic amorphous silicon film not doped with impurities, and wherein the doped silicon semiconductor film is an n-type amorphous silicon film that has been doped with n-type impurities.

10. The top gate TFT array substrate according to claim 9, wherein an undercoat film (2) is layered between a surface of the insulating substrate (1) and the intrinsic silicon semiconductor film not doped with impurities.

11. A method for manufacturing a top gate TFT array substrate provided with
a group of TFTs comprising at least:
a silicon semiconductor film deposited over an insulating substrate (1);
a gate insulator film (4') formed over a channel region of the silicon semiconductor film;
a gate electrode (5') formed over the gate insulator film (4');
a gate electrode metal-oxide film (7) covering a surface of the gate electrode (5');
a source electrode (12) covering at least a lateral surface of the gate electrode metal-oxide film (7) on the source region side and a source region; and
a drain electrode (13) formed covering at least a lateral surface on the drain region side of the gate electrode metal-oxide film (7) and a drain region, the source electrode (12) and the drain electrode (13) being separated from one another at an upper surface of the gate electrode metal-oxide film (7); and
a group of pixel electrodes formed on parts of the substrate where the TFTs (16) are not formed, and that are electrically connected to the drain region of the silicon semiconductor film via the drain electrode (13);
the method comprising:
a first layering step, in which an intrinsic silicon semiconductor film layer (3) not doped with impurities, a gate insulator film layer (4), and a gate metal film layer (5) are sequentially layered over the insulating substrate (1);
a first photolithography step, in which the gate metal film layer (5) is etched with photolithography using a first resist pattern (6), forming the gate electrode (5') and a gate metal wiring pattern electrically connected thereto;
a metal-oxide film formation step, in which a surface of the gate electrode (5') and the gate metal wiring pattern are oxidized, forming the gate electrode metal-oxide film (7) that covers an upper and a lateral surface of the gate electrode (5'), and a gate metal wiring oxide film that covers an upper and a lateral surface of the gate metal wiring pattern;
a gate insulator film formation step, in which the gate insulator film layer (4) is etched with the oxide film as a mask, forming the gate insulator film (4');
a second layering step, in which a doped silicon semiconductor film layer (8) doped with impurities, a contact metal film layer (9), and a source/drain metal film layer (10) are sequentially layered after the gate insulator film formation step;
a second photolithography step, in which the source/drain metal film layer (10), the contact metal film layer (9), and the doped silicon semiconductor film layer (8) doped with impurities, which were layered in the second layering step, and the intrinsic silicon semiconductor film layer (3) not doped with impurities are sequentially etched with photolithography using a second resist pattern (11), forming TFTs (16) on the substrate; and
a pixel electrode forming third photolithography step, in which a pixel electrode film layer (14) is deposited over the TFTs (16), after which the pixel electrode film layer (14) is etched with photolithography using a third resist pattern (15), forming a group of pixel electrodes (14') connected to the drain electrode (13).

12. The method for manufacturing a top gate TFT array substrate according to claim 11, wherein an anodization process is used in the metal-oxide film formation step.

13. The method for manufacturing a top gate TFT array substrate according to claim 12, wherein the intrinsic silicon semiconductor film layer (3) is an intrinsic amorphous silicon film layer not doped with impurities; and
wherein the doped silicon semiconductor film layer (8) is a doped amorphous silicon film layer doped with impurities.

14. The method for manufacturing a top gate TFT array substrate according to claim 13, wherein, in the second photolithographic step, the layers that have been layered over the gate electrode metal-oxide film (7) are sequentially etched until the upper surface of the gate electrode metal-oxide, film (7) is reached, forming the source electrode (12) and the drain electrode (13).

15. The method for manufacturing a top gate TFT array substrate according to any of claims 11 to 14, wherein at least the intrinsic silicon semiconductor film layer (3), the gate insulator film layer (4), and the gate metal film layer (5) are formed consecutively.

16. The method for manufacturing a top gate TFT array substrate according to any of claims 11 to 15, wherein the source/drain metal film layer (10) and the contact metal film layer (9) are formed of the same material and in a single layer.

17. The method for manufacturing a top gate TFT array substrate according to claim 16, wherein, in the first layering step, the intrinsic silicon semiconductor film layer is formed after an undercoat film has been layered on a surface of the insulating substrate (1).

18. A liquid crystal display device, comprising:
a first substrate, wherein a liquid crystal alignment film is formed on a surface of a top gate TFT array substrate, wherein pixel electrodes and TFTs driving the pixel electrodes are arranged in a matrix on an insulating substrate; and
a second substrate including a color filter and an opposing pixel electrode, the first and the second substrate being arranged in opposition to one another with their electrode surfaces facing inward, and a liquid crystal being injected into a gap between the two substrates;
wherein the top gate TFT array substrate comprises:
top gate TFTs comprising:
a silicon semiconductor film deposited over an insulating substrate (1);
a gate insulator film (4') formed over a channel region of the silicon semiconductor film;
a gate electrode (5') formed over the gate insulator film (4');
a gate electrode metal-oxide film (7) covering a surface of the gate electrode (5');
a source electrode (12) covering at least a lateral surface of the gate electrode metal-oxide film (7) on the source region side and a source region; and
a drain electrode (13) formed covering at least a lateral surface on the drain region side of the gate electrode metal-oxide film (7) and a drain region, the source electrode (12) and the drain electrode (13) being separated from one another at an upper surface of the gate electrode metal-oxide film (7); and
a pixel electrodes (14') formed on parts of the substrate where the TFTs (16) are not formed, and that are electrically connected to the drain region of the silicon semiconductor film via the drain electrode (13).

19. The liquid crystal display device according to claim 18, wherein the TFTs (16) and the pixel electrodes (14') on the top gate TFT array substrate are covered with a protective film.

20. The liquid crystal display device according to claim 19, wherein the protective film is made of an inorganic material.

21. A method for manufacturing a liquid crystal display device, comprising:
a TFT array substrate manufacturing process for manufacturing a top gate TFT array substrate including:
a group of TFTs comprising:
a silicon semiconductor film deposited over an insulating substrate (1);
a gate insulator film (4') formed over a channel region of the silicon semiconductor film;
a gate electrode (5') formed over the gate insulator film (4');
a gate electrode metal-oxide film (7) covering a surface of the gate electrode (5');
a source electrode (12) covering at least a lateral surface of the gate electrode metal-oxide film (7) on the source region side and a source region; and
a drain electrode (13) formed covering at least a lateral surface on the drain region side of the gate electrode metal-oxide film (7) and a drain region, the source electrode (12) and the drain electrode (13) being separated from one another at an upper surface of the gate electrode metal-oxide film (7); and
a group of pixel electrodes formed on parts of the substrate where the TFTs (16) are not formed, and that are electrically connected to the drain region of the silicon semiconductor film via the drain electrode (13);
an alignment film formation process, wherein a liquid crystal alignment film is formed on a surface of the TFT array substrate to make a first substrate; and
a device assembly process, wherein a liquid crystal display device is made by superposing the first substrate and a second substrate, which includes a color filter group and an opposing electrode, with their electrode surfaces facing inward, and injecting a liquid crystal into a gap between the two substrates;
wherein the TFT array substrate manufacturing process comprises:
a first layering step, wherein an intrinsic silicon semiconductor film layer (3) not doped with impurities, a gate insulator film layer (4), and a gate metal film layer (5) are sequentially layered over the insulating substrate (1);
a first photolithography step, in which the gate metal film layer (5) is etched with photolithography using a first resist pattern (6), forming the gate electrode (5') and gate metal wiring pattern electrically connected thereto;
a metal-oxide film formation step, in which the surfaces of the gate electrode (5') and the gate metal wiring pattern are oxidized to form the gate electrode metal-oxide film (7) that covers the upper and lateral surface of the gate electrode (5'), and the gate metal wiring oxide film that covers the upper and lateral surface of the gate metal wiring pattern;
a gate insulator film formation step, in which the gate insulator film layer (4) is etched, with the oxide film as a mask, forming the gate insulator film (4');
a second layering step, in which a doped silicon semiconductor film layer (8) doped with impurities, a contact metal film layer (9), and a source/drain metal film layer (10) are sequentially layered after the gate insulator film formation step;
a second photolithography step, in which the layers that have been layered in the second layering step and the intrinsic silicon semiconductor film layer (3) are sequentially etched with photolithography using a second resist pattern (11), forming a TFT (16); and
a pixel electrode forming third photolithography step of further depositing a pixel electrode film layer (14) on the substrate surface, after which the pixel electrode film layer (14) is etched with photolithography using a third resist pattern (15), forming a group of pixel electrodes (14') that are connected to the drain electrode (13), the pixel electrode forming third photolithography step being performed after the second photolithography step.

22. The method for manufacturing a liquid crystal display device according to claim 21, further comprising, between the pixel electrode formation step and the alignment film formation step, a protective film deposition step of covering the TFTs formed on the substrate and the pixel electrodes with a protective film.

23. A reflective TFT array substrate, wherein TFTs and reflective pixel electrodes driven by the TFTs are arranged in a matrix on an insulating substrate; the TFTs comprising:
a silicon semiconductor film deposited over an insulating substrate (1);
a gate insulator film (4') formed over the channel region of the silicon semiconductor film;
a gate electrode (5') formed over the gate insulator film (4');
a gate electrode metal-oxide film (7) covering a surface of the gate electrode (5');
a source electrode (42) covering at least a lateral surface of the gate electrode metal-oxide film (7) on the source region side and a source region; and
a drain electrode (43) formed covering at least the lateral surface on the drain region side of the gate electrode metal-oxide film (7) and a drain region, the source electrode (42) and the drain electrode (43) being separated from one another at the upper surface of the gate electrode metal-oxide film (7);
wherein the drain electrode (43) also functions as a reflective pixel electrode.

24. The reflective TFT array substrate according to claim 23, wherein the gate electrode metal-oxide film (7) has been made by anodizing the surface of the gate metal.

25. The reflective TFT array substrate according to claim 24, wherein the channel region of the silicon semiconductor film is made of an intrinsic silicon semiconductor film not doped with impurities, and wherein the source region and the drain region are made of a compound layer, in which a doped semiconductor film that has been doped with impurities is layered on the intrinsic silicon semiconductor film.

26. The reflective TFT array substrate according to claim 25, wherein contact electrodes (44) are disposed between the gate electrode metal-oxide film (7) and the source electrode (42), and between the gate electrode metal-oxide film (7) and the drain electrode (43), which also serves as the pixel electrode.

27. The reflective TFT array substrate according to claim 26, wherein a doped silicon semiconductor film (45) doped with impurities is disposed between the gate electrode metal-oxide film (7) and the contact electrodes (44).

28. A top gate TFT array substrate according to claim 27, wherein the surface of the gate metal wiring electrically connected to the gate electrode (5') is covered with a gate metal-oxide film of oxidized gate metal, and
wherein the source metal wiring electrically connected to the source electrode (42) and the gate metal wiring intersect via this film.

29. The reflective TFT array substrate according to claim 28, wherein the source electrode (42), the source metal wiring electrically connected thereto, the drain electrode (43) also functioning as a reflective pixel electrode, the drain metal wiring electrically connected thereto, and the contact electrodes (44) are formed by patterning a metal film layer made of the same material and in a single layer, which is deposited over the insulating substrate (1).

30. The reflective TFT array substrate according to claim 29, wherein the metal film layer made of the same material and in a single layer is made of aluminum or an aluminum alloy.

31. The reflective TFT array substrate according to any of claims 23 to 30, wherein the intrinsic silicon semiconductor film is an intrinsic amorphous silicon film not doped with impurities, and the doped silicon semiconductor film is an n-type amorphous silicon film doped with n-type impurities.

32. The reflective TFT array substrate according to any of claims 23 to 31, wherein a source wiring deposition layer including the source metal wiring is a three-layered structure made by sequentially depositing the doped silicon semiconductor film, a contact metal film, and a source metal film.

33. The reflective TFT array substrate according to claim 31 or 32,
wherein an undercoat film (2) is deposited between a surface of the insulating substrate (1) and the intrinsic silicon semiconductor film not doped with impurities.

34. A method for manufacturing a reflective TFT array substrate, the TFT array substrate comprising:
a silicon semiconductor film deposited over an insulating substrate (1);
a gate insulator film (4') formed over the channel region of the silicon semiconductor film;
a gate electrode (5') formed over the gate insulator film (4');
a gate electrode metal-oxide film (7) covering a surface of the gate electrode (5');
a source electrode (42) covering at least a lateral surface of the gate electrode metal-oxide film (7) on the source region side and a source region; and
a drain electrode (43) formed covering at least a lateral surface on the drain region side of the gate electrode metal-oxide film (7) and a drain region, the source electrode (42) and the drain electrode (43) being separated from one another at an upper surface of the gate electrode metal-oxide film (7);
wherein the drain electrode (43) also functions as a reflective pixel electrode (47);
the method comprising:
a first layering step, wherein an intrinsic silicon semiconductor film layer (3) not doped with impurities, a gate insulator film layer (4), and a gate metal film layer (5) are sequentially layered over the insulating substrate (1);
a first photolithography step, in which the gate metal film layer (5) is etched with photolithography using a first resist pattern (6), forming the gate electrode (5') and a gate metal wiring pattern electrically connected thereto;
a metal-oxide film formation step, in which the surfaces of the gate electrode (5') and the gate metal wiring pattern are oxidized to form the gate electrode metal-oxide film (7) that covers the upper and lateral surface of the gate electrode (5'), and the gate metal wiring oxide film that covers the upper and lateral surface of the gate metal wiring pattern;
a gate insulator film formation step, in which the gate insulator film layer (4) is etched, with the oxide film as a mask, forming the gate insulator film (4');
a second layering step, in which a doped silicon semiconductor film layer (8) doped with impurities, a contact metal film layer (9), and an optically reflective source/drain metal film layer (10) are sequentially deposited after the gate insulator film formation step;
a second photolithography step, in which the source/drain metal film layer (10), the contact metal film layer (9), the doped silicon semiconductor film layer (8) not doped with impurities that were layered with the second layering step, and the intrinsic silicon semiconductor film layer (3) not doped with impurities, are sequentially etched with photolithography using a second resist pattern (41) to form TFTs and reflective pixel electrodes (47) formed in one piece with the drain electrode.

35. The method for manufacturing a reflective TFT array substrate according to claim 34, wherein an anodization process is used in the metal-oxide film formation step.

36. The method for manufacturing a reflective TFT array substrate according to claim 35, wherein the intrinsic silicon semiconductor film layer (3) is an intrinsic amorphous silicon film layer that has not been doped with impurities; and
wherein the doped silicon semiconductor film layer (8) is an n-type doped amorphous silicon film layer that has been doped with n-type impurities.

37. The method for manufacturing a reflective TFT array substrate according to claim 36, wherein, in the second photolithography step, the layers that have been layered on the gate electrode metal-oxide film (7) is sequentially etched until an upper surface of the gate electrode metal-oxide film (7) is reached, forming at least the source electrode (42) and the drain electrode (43), which also functions as a reflective pixel electrode.

38. The method for manufacturing a reflective TFT array substrate according to claim 37, wherein the source/drain metal film layer (10) is formed of aluminum or an aluminum alloy.

39. The method for manufacturing a reflective TFT array substrate according to any of claims 34 to 38, wherein the source/drain metal film layer (10) and the contact metal film layer (9) are made of the same material and in a single layer.

40. The method for manufacturing a reflective TFT array substrate according to any of claims 34 to 39, wherein, in the first layering step, an undercoat film is formed between the surface of the insulating substrate and the silicon semiconductor film.

41. A reflective liquid crystal display device comprising:
a first substrate, wherein a liquid crystal alignment film is formed on a surface of a reflective TFT array substrate, wherein reflective pixel electrodes and TFTs driving the reflective pixel electrodes are arranged in a matrix on an insulating substrate; and
a second substrate including a color filter and an opposing pixel electrode arranged on the color filter, the first and the second substrate being arranged in opposition to one another with their electrode surfaces facing inward, and a liquid crystal being injected into a gap between the two substrates;
wherein the reflective TFT array substrate comprises:
a silicon semiconductor film deposited over an insulating substrate (1);
a gate insulator film (4') formed over a channel region of the silicon semiconductor film;
a gate electrode (5') formed over the gate insulator film (4');
a gate electrode metal-oxide film (7) covering the surface of the gate electrode (5');
a source electrode (42) covering at least the lateral surface of the gate electrode metal-oxide film (7) on the source region side and a source region; and
a drain electrode (43) formed covering at least the lateral surface on the drain region side of the gate electrode metal-oxide film (7) and a drain region, the source electrode (42) and the drain electrode (43) being separated from one another at the upper surface of the gate electrode metal-oxide film (7);
wherein the drain electrode (43) also functions as a reflective pixel electrode.

42. The reflective liquid crystal display device according to claim 41,
wherein the surface of the reflective TFT array substrate is covered with a protective film, and wherein the liquid crystal alignment film is formed over this protective film.

43. The reflective liquid crystal display device according to claim 41,
wherein the protective film is made of an inorganic material.

44. A method for manufacturing a liquid crystal display device, comprising:
a reflective TFT array substrate manufacturing process for manufacturing a reflective TFT array substrate including:
a silicon semiconductor film deposited over an insulating substrate (1);
a gate insulator film (4') formed over a channel region of the silicon semiconductor film;
a gate electrode (5') formed over the gate insulator film (4');
a gate electrode metal-oxide film (7) covering a surface of the gate electrode (5');
a source electrode (42) covering at least a lateral surface of the gate electrode metal-oxide film (7) on the source region side and a source region; and
a drain electrode (43) formed covering at least a lateral surface on the drain region side of the gate electrode metal-oxide film (7) and a drain region, the source electrode (42) and the drain electrode (43) being separated from one another at an upper surface of the gate electrode metal-oxide film (7), wherein the drain electrode (43) also functions as a reflective pixel electrode;
a first substrate production process of forming a liquid crystal alignment film on a surface of the reflective TFT array substrate; and
a liquid crystal cell assembly process, in which the first substrate, and a second substrate, which is provided with a color filter group and an opposing electrode, are superposed with their electrode surfaces facing inward and a liquid crystal is injected into a gap between both substrates to form a liquid crystal cell;
wherein the reflective TFT array substrate manufacturing process comprises:
a first layering step, in which at least an intrinsic silicon semiconductor film layer (3) not doped with impurities, a gate insulator film layer (4), and a gate metal film layer (5) are sequentially layered over the insulating substrate (1);
a first photolithography step, in which the gate metal film layer (5) is etched with photolithography using a first resist pattern (6), forming the gate electrode (5') and gate metal wiring pattern electrically connected thereto;
a metal-oxide film formation step, in which the surfaces of the gate electrode (5') and the gate metal wiring pattern are oxidized to form the gate electrode metal-oxide film (7) that covers the upper and lateral surface of the gate electrode (5'), and the gate metal wiring oxide film that covers the upper and lateral surface of the gate metal wiring pattern;
a gate insulator film formation step, in which the gate insulator film layer (4) is etched, with the oxide film as a mask, forming the gate insulator film (4');
a second layering step, in which a doped silicon semiconductor film layer (8) doped with impurities, a contact metal film layer (9), and an optically reflective source/drain metal film layer (10) are sequentially layered after the gate insulator film formation step;
a second photolithography step, in which the layers that have been layered in the second layering step and the intrinsic silicon semiconductor film layer (3) are sequentially etched with photolithography using a second resist pattern (41), forming a source electrode and a drain electrode also functioning as a reflective pixel electrode.

45. The liquid crystal display device manufacturing method according to claim 44, further comprising, between the reflective TFT array substrate manufacturing process and the alignment film formation process, a protective film deposition step of covering the surface of the reflective TFT array substrate with a protective film.

46. An in-plane switching TFT array substrate comprising first comb-shaped pixel electrode portions (79), second comb-shaped pixel electrode portions (80) serving as opposing electrodes, and TFTs (78) driving the first comb-shaped pixel electrode portions (79), arranged in a matrix on an insulating substrate (1);
the TFTs (78) comprising:
a silicon semiconductor film deposited over an insulating substrate (1);
a gate insulator film (73) formed over a channel region of the silicon semiconductor film;
a gate electrode (71) formed over the gate insulator film (73);
a gate electrode metal-oxide film (72) covering the surface of the gate electrode (71);
a source electrode (76') covering at least a lateral surface of the gate electrode metal-oxide film (72) on the source region side and a source region; and
a drain electrode (76") covering at least a lateral surface on the drain region side of the gate electrode metal-oxide film (72) and a drain region, the source electrode (76') and the drain electrode (76") being separated from one another at an upper surface of the gate electrode metal-oxide film (72);
wherein the first comb-shaped pixel electrode portions (79) are formed at a part of the substrate where the TFTs (78) are not formed, and comprise:
a first pixel silicon semiconductor film (3") deposited over the insulating substrate (1);
a first pixel insulator film (73') formed over the first pixel silicon semiconductor film (3");
a first pixel electrode (71') formed over the first pixel insulator film (73'); and
a first pixel electrode oxide film (72') covering an upper surface and a lateral surface of the first pixel electrode (71').

47. The in-plane switching TFT array substrate according to claim 46,
wherein the gate electrode metal-oxide film (72) and the first pixel electrode oxide film (72') are anodized films, in which the surface of electrode metal has been oxidized by anodization.

48. The in―plane switching TFT array substrate according to claim 47,
wherein the channel region of the silicon semiconductor film is made of an intrinsic silicon semiconductor film (3') not doped with impurities, and the source region and the drain region are made of two layers including the intrinsic silicon semiconductor film (3') not doped with impurities and a doped silicon semiconductor film (74') doped with impurities.

49. The in-plane switching TFT array substrate according to claim 48,
wherein the doped silicon semiconductor film (74') directly covers a lateral surface of the gate electrode metal-oxide film (72).

50. The in-plane switching TFT array substrate according to claim 49,
wherein contact electrodes (75') are disposed between the doped silicon semiconductor film (74') and the source electrode (76'), and between the doped silicon semiconductor film (74') and the drain electrode (76").

51. The in-plane switching TFT array substrate according to any of claims 46 to 50, wherein the second comb-shaped pixel electrode portions (80) are formed over the insulating substrate (1) at portions where the TFTs (78) and the first comb-shaped pixel electrode portions (79) are not formed, and include a silicon semiconductor film layer of the same material as at least the silicon semiconductor film and a metal film layer of the same material as the source electrode (76'), layered on top of one another.

52. The in-plane switching TFT array substrate according to any of claims 46 to 51, wherein the second comb-shaped pixel electrode portions (80) have the same layering structure as the layering structure including the silicon semiconductor film layer on the source region.

53. The in-plane switching TFT array substrate according to any of claims 46 to 52, wherein an undercoat film (2) is formed between the insulating substrate (1) and the silicon semiconductor film.

54. A method for manufacturing an in-plane switching TFT array substrate, wherein formed on the same substrate are:
TFTs (78) including:
a silicon semiconductor film deposited over an insulating substrate (1);
a gate insulator film (73) formed over a channel region of the silicon semiconductor film;
a gate electrode (71) formed over the gate insulator film (73);
a gate electrode metal-oxide film (72) covering a surface of the gate electrode (71);
a source electrode (76') covering at least a lateral surface of the gate electrode metal-oxide film (72) on the source region side and a source region;
a drain electrode (76") covering at least a lateral surface on the drain region side of the gate electrode metal-oxide film (72) and a drain region, the source electrode (76') and the drain electrode (76") being separated from one another at an upper surface of the gate electrode metal-oxide film (72);
first comb-shaped pixel electrode portions (79), that are formed at a part of the substrate where the TFTs (78) are not formed, and comprise:
a first pixel silicon semiconductor film (3") deposited over the insulating substrate (1);
a first pixel insulator film (73') formed over the first pixel silicon semiconductor film (3");
a first pixel electrode (71') formed over the first pixel insulator film (73'); and
a first pixel electrode oxide film (72') covering an upper surface and a lateral surface of the first pixel electrode (71'); and
second comb-shaped pixel electrode portions (80) serving as opposing electrode portions; the method comprising:
a first layering step, in which an intrinsic silicon semiconductor film layer (3) not doped with impurities, a gate insulator film layer (4), and a gate metal film layer (5) are sequentially layered over the insulating substrate (1);
a first photolithography step, in which the gate metal film layer (5) is etched with photolithography using a first resist pattern (70), forming the gate electrode (71), a gate metal wiring pattern electrically connected thereto, and the first pixel electrode (71');
a metal-oxide film formation step, in which the surfaces of the gate electrode (71), the gate metal wiring pattern, and the first pixel electrode (71') and the gate metal wiring pattern are oxidized to form the gate electrode metal-oxide film (72) that covers the upper and lateral surface of the gate electrode (71), the gate metal wiring oxide film that covers the upper and lateral surface of the gate metal wiring pattern, and the first pixel electrode oxide film (72') that covers the upper and lateral surface of the first pixel electrode (71');
an insulator film formation step, in which the gate insulator film layer (4) is etched, with the oxide film as a mask, forming the gate insulator film (73) and the first pixel insulator film (73');
a second layering step, in which a doped silicon semiconductor film layer (74) doped with impurities, a contact metal film layer (75), and a source/drain metal film layer (76) are sequentially layered after the gate insulator film formation step;
a second photolithography step, in which the source/drain metal film layer (76), the contact metal film layer (75), and the doped silicon semiconductor film layer (74) doped with impurities, which have been layered in the second layering step, and the intrinsic silicon semiconductor film layer (3) not doped with impurities are sequentially etched with photolithography using a second resist pattern (77), forming the TFTs (78), the second comb-shaped pixel electrode portions (80) and the first comb-shaped pixel electrode portions (79).

55. The method for manufacturing an in-plane switching TFT array substrate according to claim 54, wherein an anodization process is used in the metal-oxide film formation step.

56. The method for manufacturing an in-plane switching TFT array substrate according to claim 55, wherein the intrinsic silicon semiconductor film layer (3) is an intrinsic amorphous silicon film layer that has not been doped with impurities; and
wherein the doped silicon semiconductor film layer (74) is an n-type doped amorphous silicon film layer that has been doped with n-type impurities.

57. The method for manufacturing an in-plane switching TFT array substrate according to any of claims 54 to 56, wherein the second comb-shaped pixel electrode portions (80) are formed with the same layering structure as the layering structure including the layers on the source region including the silicon semiconductor film layer.

58. The method for manufacturing an in-plane switching TFT array substrate according to any of claims 54 to 57, wherein, in the second layering step, the contact metal film layer (75) and the source/drain metal film layer (76) are formed of the same material and in a single layer.

59. The method for manufacturing an in-plane switching TFT array substrate according to any of claims 54 to 58, wherein, in the first layering step, an undercoat film is formed between the insulating substrate (1) and the silicon semiconductor film.

60. An in-plane switching liquid crystal display device, wherein, on a surface of an in-plane switching TFT array substrate comprising first comb-shaped pixel electrode portions (79), second comb-shaped pixel electrode portions (80) serving as opposing electrodes, and TFTs (78) driving the first comb-shaped pixel electrode portions, arranged in a matrix on an insulating substrate (1), a first substrate, provided with a liquid crystal alignment film, and a second substrate including at least a color filter are arranged in opposition to one another with the pixel electrode and the color filter facing inward, and a liquid crystal is injected into a gap between the two substrates;
the TFTs (78) comprising:
a silicon semiconductor film deposited over the insulating substrate (1);
a gate insulator film (73) formed over a channel region of the silicon semiconductor film;
a gate electrode (71) formed over the gate insulator film (73);
a gate electrode metal-oxide film (72) covering the surface of the gate electrode (71);
a source electrode (76') covering at least a lateral surface of the gate electrode metal-oxide film (72) on the source region side and a source region; and
a drain electrode (76") covering at least a lateral surface on the drain region side of the gate electrode metal-oxide film (72) and a drain region, the source electrode (76') and the drain electrode (76") being separated from one another at an upper surface of the gate electrode metal-oxide film (72);
wherein the first comb-shaped pixel electrode portions (79) are formed at a part of the substrate where the TFTs (78) are not formed, and comprise:
a first pixel silicon semiconductor film (3") deposited over the insulating substrate (1);
a first pixel insulator film (73') formed over the first pixel silicon semiconductor film (3"),
a first pixel electrode (71') formed over the first pixel insulator film (73'); and
a first pixel electrode oxide film (72') covering an upper surface and a lateral surface of the first pixel electrode (71').

61. The in-plane switching liquid crystal display device according to claim 60, wherein the gate electrode metal-oxide film (72) and the first pixel electrode oxide film (72') are anodized films, in which a surface of electrode metal has been oxidized by anodization.

62. The in-plane switching liquid crystal display device according to claim 60 or 61, wherein the structure of the second comb-shaped pixel electrode portions (80) is the same as the layering structure of the layers including the silicon semiconductor film layer on the source region.

63. The in-plane switching liquid crystal display device according to claim 62, wherein a protective film is disposed between a surface of the in-plane switching TFT array substrate and the liquid crystal alignment film.

64. An in-plane switching TFT array substrate comprising first comb-shaped pixel electrode portions (104), second comb-shaped pixel electrode portions (103) serving as opposing electrodes, and TFTs (78) driving the first comb-shaped pixel electrode portions, arranged in a matrix on an insulating substrate (1);
the TFTs (78) comprising:
a silicon semiconductor film deposited over an insulating substrate (1);
a gate insulator film (73) formed over a channel region of the silicon semiconductor film;
a gate electrode (71) formed over the gate insulator film (73);
a gate electrode metal-oxide film (72) covering the surface of the gate electrode (71);
a source electrode (76') covering at least a lateral surface of the gate electrode metal-oxide film (72) on the source region side and a source region; and
a drain electrode (76") covering at least a lateral surface on the drain region side of the gate electrode metal-oxide film (72) and a drain region, the source electrode (76') and the drain electrode (76") being separated from one another at an upper surface of the gate electrode metal-oxide film (72);
wherein the first comb-shaped pixel electrode portions (104) are formed at a part of the substrate where the TFTs (78) are not formed;
wherein a surface of the TFTs (78) and the first comb-shaped pixel electrode portions (104) is covered by a protective film (101); and
wherein the second comb-shaped pixel electrode portions (79) are formed at a part of the substrate where the TFTs (78) and the first comb-shaped pixel electrode portions (104) are not formed.

65. The in-plane switching TFT array substrate according to claim 64,
wherein the gate electrode metal-oxide film (72) is an anodized film, in which a surface of electrode metal has been oxidized by anodization.

66. The in-plane switching TFT array substrate according to claim 65,
wherein the first comb-shaped pixel electrode portions (104) are formed with the same layering structure as the layering structure including the silicon semiconductor film layer on the source region.

67. The in-plane switching TFT array substrate according to claim 66,
wherein the second comb-shaped pixel electrode portions (103) are made of the same metal as the source electrode (76').

68. The in-plane switching TFT array substrate according to any of claims 64 to 67, wherein the intrinsic silicon semiconductor film layer (3) is an intrinsic amorphous silicon film layer not doped with impurities; and
wherein the doped silicon semiconductor film layer (74) is an n-type doped amorphous silicon film layer that has been doped with n-type impurities.

69. A method for manufacturing an in-plane switching TFT array substrate comprising:
TFTs (78) comprising:
a silicon semiconductor film deposited over an insulating substrate (1);
a gate insulator film (73) formed over a channel region of the silicon semiconductor film;
a gate electrode (71) formed over the gate insulator film (73);
a gate electrode metal-oxide film (72) covering the surface of the gate electrode (71);
a source electrode (76') covering at least a lateral surface of the gate electrode metal-oxide film (72) on the source region side and a source region; and
a drain electrode (76") covering at least a lateral surface on the drain region side of the gate electrode metal-oxide film (72) and a drain region, the source electrode (76') and the drain electrode (76") being separated from one another at an upper surface of the gate electrode metal-oxide film (72);
first comb-shaped pixel electrode portions (104) formed at a part of the substrate where the TFTs (78) are not formed;
a protective film (101) covering a surface of the substrate including the TFTs (78) and the first comb-shaped pixel electrode portions (104);
second comb-shaped pixel electrode portions (103) serving as opposing electrodes, formed at a part of the substrate where the TFTs (78) and the first comb-shaped pixel electrode portions (104) are not formed, and formed on the protective film (101);
the method comprising:
a first layering step, in which an intrinsic silicon semiconductor film layer (3) not doped with impurities, a gate insulator film layer (4), and a gate metal film layer (5) are sequentially layered over the insulating substrate (1);
a first photolithography step, in which the gate metal film layer (5) is etched with photolithography using a first resist pattern (100), forming the gate electrode (71) and a gate metal wiring pattern electrically connected thereto;
a metal-oxide film formation step, in which the surfaces of the gate electrode (71) and the gate metal wiring pattern are oxidized to form the gate electrode metal-oxide film (72) that covers the upper and lateral surface of the gate electrode (71) and the gate metal wiring oxide film that covers the upper and lateral surface of the gate metal wiring pattern;
an insulator film formation step, in which the gate insulator film layer (4) is etched, with the oxide film as a mask, forming the gate insulator film (73);
a second layering step, in which a doped silicon semiconductor film layer (74) doped with impurities, a contact metal film layer (75), and a source/drain metal film layer (76) are sequentially layered after the gate insulator film formation step;
a second photolithography step, in which the source/drain metal film layer (76), the contact metal film layer (75), and the doped silicon semiconductor film layer (74) doped with impurities, which have been layered in the second layering step, and the intrinsic silicon semiconductor film layer (3) not doped with impurities are sequentially etched with photolithography using a second resist pattern (102), forming the TFTs (78) and the first comb-shaped pixel electrode portions (104);
a protective film deposition step, in which, after the second photolithography step, a protective film (101) is deposited, covering a surface of the TFTs (78) and the first comb-shaped pixel electrode portions (104) formed on the substrate surface;
a metal film deposition step, in which a metal film layer for forming the second comb-shaped pixel electrode is deposited on the protective film (101);
a second comb-shaped pixel electrode forming third photolithography step of etching the metal film layer with photolithography using a third resist pattern (106), forming second comb-shaped pixel electrodes (103) serving as opposing electrodes, the second comb-shaped pixel electrode forming third photolithography step being performed after the metal film deposition step.

70. The method for manufacturing an in-plane switching TFT array substrate according to claim 69, wherein the oxidation method in the metal-oxide film formation step is anodization.

71. The method for manufacturing an in-plane switching TFT array substrate according to claim 70, wherein the intrinsic silicon semiconductor film layer (3) is an intrinsic amorphous silicon semiconductor film layer not doped with impurities; and
wherein the doped silicon semiconductor film layer (74) is an n-type doped amorphous silicon film layer that has been doped with n-type impurities.

72. The method for manufacturing an in-plane switching TFT array substrate according to claim 71, wherein the first comb-shaped pixel electrode portions (104) are formed with the same layering structure as the layering structure on the drain region including the silicon semiconductor film layer.

73. The method for manufacturing an in―plane switching TFT array substrate according to any of claims 69 to 72, wherein, in the second layering step, the contact metal film layer (75) and the source/drain metal film layer (76) are formed of the same material and in a single layer.

74. The method for manufacturing an in-plane switching TFT array substrate according to any of claims 69 to 73, wherein, in the first layering step, an undercoat film is formed between the insulating substrate (1) and the silicon semiconductor film.

75. An in-plane switching liquid crystal display device, wherein, on a surface of an in-plane switching TFT array substrate comprising first comb-shaped pixel electrode portions (104), TFTs (78) driving the first comb-shaped pixel electrode portions, and second comb-shaped pixel electrode portions (103) serving as opposing electrodes formed on a silicon protective film covering a surface of at least the first comb-shaped pixel electrode portions (104) and the TFTs (78), a first substrate, provided with a liquid crystal alignment film, and a second substrate including at least a color filter are arranged in opposition to one another with the pixel electrode and the color filter facing inward, and a liquid crystal is injected into a gap between the two substrates;
the TFTs (78) comprising:
a silicon semiconductor film deposited over an insulating substrate (1);
a gate insulator film (73) formed over a channel region of the silicon semiconductor film;
a gate electrode (71) formed over the gate insulator film (73);
a gate electrode metal-oxide film (72) covering the surface of the gate electrode (71);
a source electrode (76') covering at least a lateral surface of the gate electrode metal-oxide film (72) on the source region side and a source region; and
a drain electrode (76") covering at least a lateral surface on the drain region side of the gate electrode metal-oxide film (72) and a drain region, the source electrode (76') and the drain electrode (76") being separated from one another at an upper surface of the gate electrode metal-oxide film (72);
wherein the first comb-shaped pixel electrode portions (104) are formed at a part of the substrate where the TFTs (78) are not formed,
wherein a surface of the TFTs (78) and the first comb-shaped pixel electrode portions (104) is covered by a protective film (101); and
wherein the second comb-shaped pixel electrode portions (79) are formed on the protective film (101) at a part of the substrate where the TFTs (78) and the first comb-shaped pixel electrode portions (104) are not formed.

76. The in-plane switching liquid crystal display device according to claim 75, wherein the gate electrode metal-oxide film (72) and the first pixel electrode oxide film (72') are anodized films, in which the surface of electrode metal has been oxidized by anodization.

77. The in-plane switching liquid crystal display device according to claim 75 or 76, wherein the structure of the first comb-shaped pixel electrode portions (104) is the same as the layering structure of the layers on the source region including the silicon semiconductor film layer.

78. The in-plane switching liquid crystal display device according to claim 77, wherein a second protective film is disposed between a surface of the in-plane switching TFT array substrate and the liquid crystal alignment film.
